# EUROPEAN PATENT APPLICATION

(11) **EP 2 197 040 A1**
(43) Date of publication of application: **16.06.2010**
(21) Application number: 08834602.8
(22) Date of filing: 26.09.2008
(51) Int. Cl.: H01L 31/04

(54) **SOLAR CELL**

(30) Priority: 28.09.2007 JP 2007255664; 30.03.2008 JP 2008088958
(71) Applicant: Fujifilm Corporation, Tokyo 106-8620 (JP)
(72) Inventor: YAGO, Haruo, Ashigarakami-gun Kanagawa 258-8577 (JP); AONO, Naruhiko, Ashigarakami-gun Kanagawa 258-8577 (JP); HOSOYA, Youichi, Ashigarakami-gun Kanagawa 258-8577 (JP); SATO, Tadanobu, Ashigarakami-gun Kanagawa 258-8577 (JP)
(74) Representative: HOFFMANN EITLE
(86) International application number: PCT/JP2008/067558
(87) International publication number: WO 2009/041659

(57) **Abstract**

A solar cell, comprising: a metal substrate having an insulating anodic oxidation film; and a photoelectric conversion layer provided on the metal substrate, whereon the anodic oxidation film has a surface roughness of 0.5 nm to 2 µm, and the photoelectric conversion layer comprises a chalcopyrite semiconductor material having a band gap of 1.3 eV to 1.5 eV.

## Description

### TECHNICAL FIELD

The present invention relates to thin-film solar batteries and more specifically to a lightweight, highly flexible thin-film solar cell produced with an anodized aluminum substrate.

### BACKGROUND ART

Glass substrates are mainly used as thin-film solar cell substrates. However, a glass substrate is fragile and must be treated with considerable care and its lack of flexibility limits the scope of the application. Recently, solar batteries have attracted much attention as power supply sources to buildings including homes. It is inevitable to upsize solar batteries in order to ensure sufficient electric power to supply, and there has been a demand for a more lightweight substrate that should contribute to production of solar batteries with larger areas.
However, a glass substrate would be even more fragile if it is thinned for reduction in weight. Therefore, there has been a demand for development of a less fragile and more flexible substrate material that can be reduced in weight as compared to the glass substrate.

The glass substrate is relatively expensive as compared to a photoelectric conversion layer material for a solar cell, and an inexpensive substrate material is desired in the expectation that such an inexpensive material will help promote the use of solar batteries. If a metal is used as such a substrate material, its insulation from a solar cell material arranged thereon is difficult, while a resin substrate cannot withstand a high temperature exceeding 400°C that is necessary to form a solar cell.
Furthermore, in a chalcopyrite material with higher light absorption efficiency, sufficient light cannot be confined, and incoming sunlight is not used effectively.

### DISCLOSURE OF INVENTION

The present invention has been made in view of the above circumstances and can provide a lightweight, less fragile and more flexible solar cell having high thermal conductivity, high peeling resistance for its photoelectric conversion layer, and favorable voltage resistance, and having an optimized light absorption layer band gap or being capable of having high efficiency upon an increase in light utilizing efficiency.

According to the present invention, there is provided the following means:
(1) A solar cell, comprising: a metal substrate having an insulating anodic oxidation film; and a photoelectric conversion layer provided on the metal substrate, wherein the anodic oxidation film has a surface roughness of 0.5 nm to 2 µm, and the photoelectric conversion layer comprises a chalcopyrite semiconductor material having a band gap of 1.3 eV to 1.5 eV.
(2) The solar cell of item (1), wherein the roughness of the anodic oxidation film is 0.5µm to 1.5µm.
(3) The solar cell of item (1) or (2), wherein pores with a pore size of 10 nm to 500 nm are formed on the surface of the anodic oxidation film.
(4) The solar cell of item (3), wherein the pores have a pore size of 10 nm to 200 nm.
(5) The solar cell of any one of items (1) to (4), wherein the pores satisfy the relationship D>R, wherein D is a distance between the centers of the adjacent pores formed on the anodic oxidation film, and R is a pore diameter, and wherein the pores are present at a density of 100 to 10,000 per µm².
(6) The solar cell of any one of items (1) to (5), wherein the pores have a depth of 0.005 to 199.995 µm.

(7) The solar cell of any one of items (1) to (6), wherein the anodic oxidation film has a textured surface structure defined by fractal analysis, wavelet analysis or Fourier transform method.
(8) The solar cell of item (7), wherein the textured structure includes a fractal structure with a fractal dimension of higher than 2 to 2.99.
(9) The solar cell of item (8), wherein the fractal dimension is higher than 2 to 2.99, when a unit length is more than 1 nm to 100 µm in size.
(10) The solar cell of item (7), wherein a cross section of the textured structure has a fractal structure with a fractal dimension of higher than 1 to 1.99.
(11) The solar cell of item (10), wherein the fractal dimension is higher than 1 but not higher than 1.99, when the unit length is more than 1 nm to 100 µm in size.

(12) The solar cell of any one of items (1) to (11), wherein the anodic oxidation film is formed on an end face and both sides of the metal substrate.
(13) The solar cell of any one of items (1) to (12), wherein the photoelectric conversion layer comprises a semiconductor layer comprising Group Ib elements, IIIb elements and VIb elements.
(14) The solar cell of item (13), wherein the semiconductor layer comprises at least one element selected from the group consisting of copper (Cu), silver (Ag), indium (In), gallium (Ga), sulfur (S), selenium (Se), and tellurium (Te).
(15) The solar cell of any one of items (1) to (12), wherein the photoelectric conversion layer comprises a semiconductor layer comprising a Group IVb element, a semiconductor layer comprising Group IIIb elements and Vb elements, a semiconductor layer comprising Group IIb elements and VIb elements, a layer comprising a Group Ib element, a layer comprising a Group IIb element, a layer comprising a Group IVb element, and/or a layer comprising a Group VIb element.

Other and further features and advantages of the invention will appear more fully from the following description, taking the accompanying drawing into consideration.

### BRIEF DESCRIPTION OF DRAWINGS

[Fig. 1] Fig. 1 is a schematic cross-sectional view of an apparatus for water washing with a freely-falling curtain-like liquid film;
[Fig. 2] Fig. 2 is a graph showing an example of a trapezoidal wave for use in an electrochemical surface roughening treatment;
[Fig. 3] Fig. 3 is a schematic diagram of a radial type electrolytic apparatus suitable for use in an embodiment of the invention;
[Fig. 4] Figs. 4(a) to 4(d) are each a cross-sectional view of a device for illustrating a general method of producing cells of a CIGS thin-film solar cell;
[Fig. 5] Fig. 5 is a diagram showing the relationship between the lattice constant and the band gap of semiconductors composed of Group Ib elements, IIIb elements and VIb elements;
[Fig. 6] Fig. 6 is a graph showing the result of measurement of the fractal dimension of the cross-sectional shape of the textured surface structure of an anodized aluminum substrate; and
[Fig. 7] Fig. 7 is a diagram showing the band gap of a solar cell produced in the example.

### BEST MODE FOR CARRYING OUT INVENTION

Solar batteries generally have such a structure that a photoelectric conversion semiconductor layer is interposed between two electrodes including a transparent electrode. If light incident through the transparent electrode is reflected and allowed to go and return many times in the semiconductor layer so that the light can be more efficiently confined, the power generation efficiency can be increased. If the surface of the counter electrode has a textured structure, the light may change in traveling direction upon reflection on the electrode and obliquely propagate through the semiconductor layer, which may lead to an increase in light absorption probability. An increase in obliquely propagating light may also result in an increase in the tilt angle with respect to the transparent electrode and the semiconductor layer and an increase in the reflectivity of the interface between the transparent electrode and the air or the like, so that the light, once reflected from the counter electrode, can be confined in the solar cell.

In conventional techniques, therefore, it has been tried to form a textured structure at the interface between the semiconductor and the counter electrode. For example, Japanese Patent Application Laid-Open (JP-A) No. 2007-194569 discloses a process including coating a thin metal plate with a resin having a thermal decomposition temperature of 250°C or higher and a glass transition temperature of 350°C or lower and forming a fine regularly textured structure on the surface of the resin so that a solar cell substrate is obtained. However, the heat resistance of such a substrate is not sufficient for CIGS solar batteries or the like.
JP-A Nos. 2005-340643, 2004-134494 and 2004-31648 disclose that a semiconductor substrate is immersed in an acid solution and an alkali solution, so that a semiconductor substrate whose surface has a light-confining textured structure is obtained. However, such a semiconductor substrate is not suitable for thin-film solar batteries.
JP-A Nos. 2005-311292, 2004-82285 and 2003-282902 disclose that an optically-transparent insulating substrate having a finely textured surface is used as a thin-film solar cell substrate, and the thin-film solar cell has a transparent electrode layer formed on the textured surface of the substrate. However, a glass substrate has to be used to form such a solar cell.

In contrast, the solar cell substrate for use in an embodiment of the invention includes a flexible metal substrate and an insulating layer formed thereon by anodic oxidation, and therefore, a textured structure can be inexpensively formed on the substrate. Thus, a substrate with favorable heat resistance and high flexibility can be obtained in place of a glass substrate without etching the semiconductor layer. Using such a substrate makes it possible to produce, at low cost, a lightweight flexible solar cell having high thermal conductivity and crack resistance.

The surface of the insulating film on the anodized metal substrate has a textured structure due to pore or the like and preferably has a surface roughness Ra of 0.5 nm to 2 µm. The surface roughness Ra is preferably from 0.5 µm to 1.5 µm for a thin-film solar cell. In order to prevent the anodic oxidation film from having defects and so on and from being degraded in insulating properties, it is preferred that the anodic oxidation film should be microscopically flat but have an undulating structure as a higher-order structure. Such a texture may be realized by subjecting the metal surface to mechanical polishing, chemical polishing, electric polishing, or combination thereof, before the anodic oxidation.

The textured structure of the surface of the anodic oxidation film may be defined by fractal analysis, wavelet analysis or Fourier transform method.
The fractal dimension may be evaluated from a three-dimensional structure or a two-dimensional, cross-sectional structure. In an embodiment of the invention, the textured structure of the surface of the anodic oxidation film and the cross-section thereof preferably include a fractal structure. In an embodiment of the invention, the textured structure (three-dimensional structure) of the surface of the anodic oxidation film preferably has a fractal dimension of higher than 2 to 2.99, as a result of evaluation. The structure may vary with the scale range used in the evaluation. When the unit length is in the size of 1 nm or more to 1,000 µm or less in the fractal evaluation, the fractal dimension is preferably in the range of higher than 2 to 2.99, more preferably 2.5 or lower.
In an embodiment of the invention, a section (second-dimensional cross sectional structure) of the textured structure of the surface of the anodic oxidation film preferably has a fractal dimension of higher than 1 to 1.99, as a result of evaluation. The structure may vary with the scale range used in the evaluation. When the unit length is in the range of 1 nm or more to 1,000 µm or less in the fractal evaluation, the fractal dimension is preferably in the range of higher than 1 to 1.99, more preferably 1.5 or lower.

As used herein, the term "fractal structure" refers not only to a strict fractal structure in which a regular self-similarity appears even if the scale is changed but to a structure including a random structure such as topographical contours and a structure whose fractal dimension can be defined by a process such as scale transformation and box counting.
There are various fractal evaluation methods. For example, the interface structure of the anodized aluminum surface may be extracted and evaluated by a box-counting method. At the time, the fractal dimension preferably decreases as the unit length for evaluation decreases.
According to the box counting method, a fractal dimension called "box dimension" is determined.
This method is not sensitive about the way of selecting boxes, so that it is widely applicable in practical dimension measurement and often used to measure the fractal dimension of a complex curve such as a coastline. For example, according to the divider (cover) method, in particular, the necessary number of steps Nδ taken to walk the length of a curve is determined with different strides δ, and the fractal dimension is determined based on the gradient of the log-log plots of the results, D=-log Nδ/logδ. This corresponds to the case in which circles (spheres) that do not overlap one another are employed as boxes. The above "unit length" corresponds to the stride δ in this case. Some actually existing asperities having a size less than the minimum resolution may not be observed visually. This corresponds to the case where when the observation magnification is changed in an AFM, the minimum resolution increases correspondingly. The minimum resolution may be reduced in calculation and the number of the minimum units that can be arranged on the section may be calculated, so that the dimension can be obtained. It is a fractal characteristic that D does not change as δ is changed from a large value to a small value, but δ cannot be considered in the range from the infinity to the infinitesimal for actual materials. In an embodiment of the invention, it is assumed that a fractal dimension can be defined in such a narrow range of about δ to several multiples of δ instead of the whole range of δ

The surface roughening method may be a method using sand, a brush, AC electrolysis, or the like. The surface roughening method enables use of different aluminum materials with different compositions and is also effective in preventing a reduction in the quality of alumina (streaks), which is caused by variations in crystal grain. Polishing into a mirror state is preferably followed by anodic oxidation so that the roughness Ra can be from 0.5 nm to 2 µm. Specific methods are described below.

Before the anodic oxidation, surface roughening is performed using a brush and an abrasive material-containing slurry. Electrical or mechanical surface roughening, AC surface roughening, surface roughening by alkali etching, electrochemical surface roughening, or neutral DC etching-hydrochloric acid AC electrochemical surface roughening-neutral DC etching-hydrochloric acid AC electrochemical surface roughening-neutral DC etching-sulfuric acid DC desmutting (to remove powdered black particles (smut)) may be followed by the anodic oxidation.
An anodized aluminum substrate may be obtained by performing anodic oxidation as described in JP-A No. 2005-47084, 2005-47070 or 2005-254638.

Asperities may also be formed by controlling the pore size and the density of pores formed on the anodic oxidation film. Small asperities for thin-film solar batteries may be formed by a method including subjecting the metal surface to mechanical polishing, chemical polishing, electric polishing, or combination thereof before anodic oxidation, and then subjecting the surface to anodic oxidation. Therefore, polishing into a mirror state is preferably followed by anodic oxidation so that the surface roughness Ra can be from 0.5 to 50 nm.

The pore size of pores formed by the anodic oxidation is preferably from 10 nm to 500 nm, more preferably from 10 nm to 200 nm. Pores are preferably formed at a density of 100 to 10,000 per µm² so as to satisfy the relationship D>R, wherein D is a distance between the centers of the adjacent pores and R is a pore diameter.

The anodic oxidation film may be widely classified into a barrier layer, which is a dense oxide film, and a pore layer having pores. In an embodiment of the invention, to ensure the insulation, the barrier layer of the anodic oxidation film preferably has a thickness of 5 to 500 nm, and the thickness of the whole of the anodic oxidation film (namely, the total of the thicknesses of the barrier layer and the pore layer) is preferably from 0.1 to 200 µm.

The process of roughening the surface of the metal substrate (such as an aluminum substrate) so that the surface of the aluminum oxide layer can have asperities is effective not only for optical confinement but also in improving the adhesion between alumina and an electrically-conductive layer (metal or semiconductor) formed thereon so that particularly peeling between metal layers whose thermal expansion coefficients differ (significantly) from one another can be prevented.

The metal substrate to be used may be made of a material from which a metal oxide film can be formed as an insulator on the surface by anodic oxidation. The thermal expansion coefficients of metal oxide films are generally smaller than those of metals and close to those of semiconductors. Therefore, the oxide film formed on the surface of the metal substrate preferably has a thermal expansion coefficient almost equal to that of the material used to form the photoelectric conversion layer. Examples of such a material include aluminum (Al), zirconium (Zr), titanium (Ti), magnesium (Mg), niobium (Nb), tantalum (Ta), and an alloy thereof. In view of cost and the characteristics required for solar batteries, aluminum is most preferred.

A Group I-III-VI semiconductor composed of copper (Cu), silver (Ag), gallium (Ga), indium (In), sulfur (S), selenium (Se), tellurium (Te), and so on may be used to form a copper-indium-gallium-selenium (CIGS) solar cell. Concerning this case, the thermal expansion coefficient of Mo of the back side electrode layer (5 × 10⁻⁶/K) is smaller than that of soda-lime glass or that of CIGS (9 × 10⁻⁶/K). A stainless steel substrate has a thermal expansion coefficient of 10 × 10⁻⁶/K. In the anodized aluminum substrate, however, the anodic oxidation (alumina) film has a thermal expansion coefficient of 7.5 × 10⁻⁶/K, which is closer to that of Mo than to that of stainless steel. Therefore, thermal distortion will be reduced during the film forming process when the anodized aluminum substrate is used than when a stainless steel substrate is used. Therefore, curving, curling, or peeling of a film can be prevented.

Aluminum has a thermal expansion coefficient of 22x10⁻⁶/K. There is a difference in thermal expansion between aluminum and the anodic oxidation film made of alumina. Therefore, anodic oxidation films having substantially the same thickness are more preferably formed on both sides of the aluminum substrate.

For example, both sides may be anodized by a method of anodizing the sides one by one with one side coated with an insulating material or by a method of anodizing both sides at the same time.

The process of forming an oxide film on the metal substrate preferably includes forming the oxide film also on the end faces so that the metal part can be entirely covered with the oxide film. In this case, the metal can be prevented from reacting with chemical substances used as raw materials for forming a photoelectric conversion layer on the substrate, or the photoelectric conversion part-forming layer can be prevented from being contaminated with the material of the substrate, so that the photoelectric conversion efficiency of the solar cell can be prevented from being degraded or quickly reduced (particularly in vapor deposition of CIGS, selenium or sulfur is prevented from reacting with aluminum).

The aluminum substrate is provided with an anodic oxidation film as described above. A photoelectric conversion layer including a chalcopyrite copper-indium-selenium compound (CIS) or copper-indium-gallium-selenium compound (CIGS) including a semiconductor composed of Group Ib elements, IIIb elements and VIb elements such as Cu, Ag, In, Ga, S, Se, and Te (Group I-III-VI semiconductor); a semiconductor composed of Group IIb elements and VIb elements such as CdTe (Group II-VI semiconductor); a semiconductor including a Group IVb element such as Si (Group IV semiconductor); or a semiconductor composed of Group IIIb elements and Vb elements such as GaAs (Group III-V semiconductor) may be formed on such a substrate so that a solar cell can be obtained. In the description, the short periodic table is used to describe group elements.

### Aluminum Substrate

An aluminum substrate may be used in an embodiment of the invention. Such an aluminum substrate is a dimensionally-stable metallic substrate including aluminum as a primary component, such as a substrate made of aluminum or an aluminum alloy. A pure aluminum sheet, an alloy sheet including aluminum as a primary component and a trace amount of a different element(s), or an aluminum- or aluminum alloy-laminated or vapor-deposited plastic film or paper sheet may also be used. Although the composition of the aluminum sheet for use in an embodiment of the invention is not restricted, a pure aluminum sheet is preferably used.

Such a high purity aluminum material preferably has a purity of 99.9% by weight or higher. As the purity of the aluminum material increases, the order of the pores becomes higher after the anodic oxidation, and the size (average pore period) of the region having the order also becomes wider. For electromagnetic device applications, therefore, an aluminum material having a purity as high as possible is preferably used. The purity is preferably 99.99% by weight or higher, more preferably 99.995% by weight or higher, even more preferably 99.999% by weight or higher. Many of commercially available materials with a purity of 99.9% by weight or higher to 99.99% by weight or lower have no blister, although they sometimes have rolling stripes. However, materials with a purity of higher than 99.99% by weight are generally available by special order and often produced with small-scale experimental equipment, when supplied, and they are generally sheet materials having blisters on one level or another.

Aluminum with a purity of 99.99% by weight to 99.999% by weight is generally called high purity aluminum, and aluminum with a purity in a range of 99.999% by weight or higher is called ultrahigh purity aluminum. An aluminum material with a purity of higher than 99.99% by weight is produced by repeated melting and refining in a melting furnace. In the melting process, agitation is performed using gas such as air or inert gas, and therefore, bubbles are trapped. Thereafter, degassing is performed under reduced pressure. In the case of high-purity materials, a very trace amount of impurities must be allowed to float on the surface layer, which requires strong agitation, so that the content of bubbles may be high and that degassing may tend to be insufficient. If such an aluminum material containing bubbles is rolled, a convex portion with a diameter of about 50 µm to about 2 mm or about 0.1 to about 1 mm and a depth of about 0.1 to about 20 µm or about 0.3 to about 10 µm, called "blister" may be formed. Such portions are generally formed at a density of several per dm² to hundreds per dm². Rolling stripes as mentioned above may also be generated by rolling.

Since completely pure aluminum is difficult to produce from the viewpoint of refining technology, the material to be used may contain a trace amount of a different element(s). For example, known materials as described in Aluminum Handbook, 4th ed., Japan Light Metals Association (1990), such as JIS 1050, JIS 1100, JIS 3003, and JIS 3005 materials, and internationally registered alloy 3103A may be used.
An aluminum alloy having an aluminum (Al) content of 99.4 to 95% by weight and containing at least the following five kinds of iron (Fe), silicon (Si), copper (Cu), magnesium (Mg), manganese (Mn), zinc (Zn), chromium (Cr), and titanium (Ti) in amounts ranging as described below, a scrap aluminum material, or an aluminum sheet produced with secondary aluminum may also be used. In an embodiment of the invention, an aluminum alloy is preferably used for the substrate (support) of the solar cell. The aluminum alloy preferably contains Fe, Si and Cu, and more preferably further contains Ti.

The aluminum alloy (Al ingot) to be used as a raw material generally contains about 0.04 to 0.2% by weight of Fe. The amount of Fe present in the form of a solid solution in aluminum is small, and most of Fe is present in the form of an intermetallic compound. Fe is effective in increasing the mechanical strength of the aluminum alloy and has a significant effect on the strength of the support. If the Fe content is too low, the mechanical strength of the substrate may be too low, so that the substrate may be susceptible to breaking in the process of placing it in a vapor deposition apparatus and that the substrate may also be susceptible to breaking in the process of performing vapor deposition at high speed on a large number of substrates. If the Fe content is too high, the strength of the substrate may be unnecessarily high, so that the substrate may have a low level of fitness in the process of placing it in a vapor deposition apparatus and may be susceptible to breaking during vapor deposition. For example, if the Fe content is higher than 1.0% by weight, cracking may easily occur during rolling.

The upper limit of the Fe content is preferably 0.29% by weight, so that high mechanical strength can be obtained. In this case, the amount of the Fe-containing intermetallic compound is reduced, so that the number of local depressions formed after the intermetallic compound is removed (or drops off) is small, which leads to a reduction in defects of the crystal consisting the photoelectric conversion layer, favorable in-plane distribution of the electric generation efficiency, and high electric generation efficiency. In view of the Fe content of ingots, the lower limit of the Fe content is preferably and reasonably 0.05% or higher. The lower limit of the Fe content is more preferably 0.20% by weight or higher in terms of maintaining the mechanical strength. Examples of Fe-containing intermetallic compounds include Al₃Fe, Al₆Fe, Al-Fe-Si compounds, and Al-Fe-Si-Mn compounds.

Si is an inevitable impurity element, and an Al ingot as a raw material generally contains about 0.03 to about 0.1% by weight of Si. Si is often intentionally added in a very trace amount so that different raw materials will not cause variations. Si is also contained in a relatively large amount in scrap aluminum. Si is present in the form of a solid solution, an intermetallic compound or a simple precipitate in aluminum. When the solar cell substrate is heated in the manufacturing process, simple Si may be precipitated from a solid solution of Si. The inventors have found that Si has an effect on electrolytic surface roughening. In addition, if the Si content is too high, a defective anodic oxidation film may be produced in the anodizing treatment after the surface roughening treatment.

In an embodiment of the invention, the Si content is preferably 0.03% by weight or higher and 0.15% by weight or lower. In view of high stability of electrolytic surface roughening, the Si content is more preferably 0.04% by weight or higher and 0.1% by weight or lower.

Cu is a very important element in controlling electrolytic surface roughening. The Cu content is preferably 0.000% by weight or higher, further preferably 0.020% by weight or higher, so that electrolytic surface roughening in a nitric acid solution can produce pits with a large diameter, which leads to an increase in adhesion. However, if the Cu content is higher than 0.15% by weight, the diameters of the pits produced by electrolytic surface roughening in a nitric acid solution may be too large and less uniform, so that a uniform surface cannot be obtained in some cases.

In an embodiment of the invention, the Cu content is preferably from 0.000 to 0.150% by weight, more preferably from 0.05 to 0.1% by weight, from the above point of view.

Ti has been used as a grain refining agent to refine the crystal structure during casting, and Ti is generally contained in a content of 0.05% by weight or lower. If the Ti content is too high, the film may suffer from dielectric breakdown during anodic oxidation, so that a uniform anodic oxidation film surface cannot be obtained in some cases. In an embodiment of the invention, the Ti content is preferably 0.05% by weight or lower, more preferably 0.03% by weight or lower.

Ti does not have to be contained in the aluminum sheet, and the Ti content may be low. In order to enhance the grain refining effect, however, the Ti content is preferably 0.001% by weight or higher.

Ti is generally added in the form of an intermetallic compound with Al or in the form of TiB₂. In order to enhance the grain refining effect, however, Ti is preferably added in the form of an Al-Ti alloy or an Al-B-Ti alloy. When Ti is added in the form of an Al-B-Ti alloy, a very trace amount of boron (B) is also added to the aluminum alloy, which does not reduce the effect of the invention.

When the aluminum sheet containing each of the above different elements in the above content range is used, large pits are uniformly formed in the electrolytic surface roughening treatment described below, so that the adhesion of the aluminum sheet is favorable in the resulting solar cell.

The balance of the aluminum sheet is preferably composed of Al and inevitable impurities. Most of the inevitable impurities are contained in the Al ingot. For example, when contained in an Al ingot with a purity of 99.7%, the inevitable impurities do not reduce the effect of the invention. For example, the inevitable impurities may be contained in amounts as described in L. F. Mondolfo, "Aluminum Alloys: Structure and Properties" (1976).

Examples of inevitable impurities contained in aluminum alloys include Mg, Mn, Zn, and Cr, each of which may be contained in an amount of 0.05% by weight or lower. Any additional element other than these elements may also be contained in an amount known in the art.

The aluminum sheet for use in an embodiment of the invention may be produced by a process including subjecting the above raw material to casting by a ordinary method, subjecting the cast product to an appropriate rolling process and appropriate heat treatment, for example, to produce a 0.1 to 0.7 mm thick product, and optionally performing a flatness correcting process. The thickness may be changed as appropriate.

Examples of methods that may be used to produce the aluminum sheet include a DC casting method, a method of performing DC casting, excluding soaking and/or annealing, and a continuous casting method.

### Manufacture of Solar Cell Substrate

The substrate for use in the solar cell of the invention may be produced by a process including subjecting the above aluminum sheet to a surface roughening treatment or a polishing process, then subjecting it to anodic oxidation, and subjecting it to a specific sealing process.

### Solar Cell Substrate Manufacturing Process

The aluminum sheet is preferably subjected to a degreasing process to remove rolling oil adhering thereto; a desmutting process to dissolve smut on the surface of the aluminum sheet; a surface roughening treatment process to roughen the surface of the aluminum sheet; an anodizing treatment process to form an anodic oxidation film on the surface of the aluminum sheet; and a sealing process to seal the micropores of the anodic oxidation film, so that a solar cell substrate is obtained.

The process of manufacturing the solar cell substrate for use in an embodiment of the invention preferably includes a surface roughening treatment in which the surface of the aluminum sheet is electrochemically roughen using an alternating current in an aqueous acid solution (an electrochemical surface roughening treatment).

Besides the above-described electrochemical surface roughening treatment, the process of manufacturing the solar cell substrate according to the invention may also include an aluminum sheet surface-treating process in which a mechanical surface roughening treatment, a chemical etching treatment in an aqueous acid or alkali solution and so on are performed in combination. In the process of manufacturing the solar cell substrate according to the invention, the respective treatments including the surface roughening treatment may be continuously or intermittently performed. Using a continuous process is industrially preferred.
In an embodiment of the invention, a hydrophilizing treatment may also be performed as needed.

More specifically, a method for manufacturing the solar cell substrate according to the invention preferably includes (a) a mechanical surface roughening treatment, (b) an alkali etching treatment, (c) a desmutting treatment, (d) an electrolytic surface roughening treatment with an electrolyte mainly composed of nitric acid or hydrochloric acid (nitric acid or hydrochloric acid electrolysis), (e) an alkali etching treatment, (f) a desmutting treatment, (g) an electrolytic surface roughening treatment with an electrolyte mainly composed of hydrochloric acid (hydrochloric acid electrolysis), (h) an alkali etching treatment, (i) a desmutting treatment, (j) an anodizing treatment, (k) a sealing treatment, and (l) a hydrophilizing treatment, which are performed in this order.
Also preferably used is a method of performing the treatments excluding the treatments (g) to (i), a method of performing the treatments excluding the treatment (a), a method of performing the treatments excluding the treatments (a) and (g) to (i), or a method of performing the treatments excluding the treatments (a) to (d).

### Water Washing Treatment

A water washing treatment is generally performed between the respective treatments in order to avoid contamination of the following process with the treatment liquid.
The water washing treatment is preferably performed using an apparatus which performs water washing with a freely-falling curtain-like liquid film and further preferably performed using a spray tube.

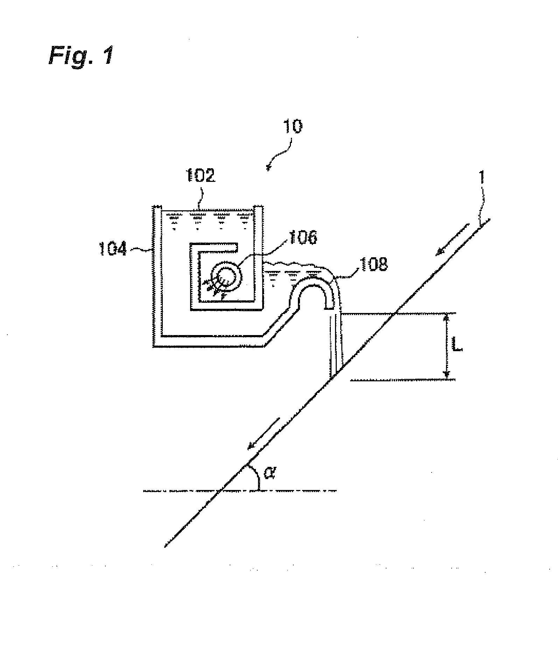

Fig. 1 is a schematic cross-sectional view of an apparatus for performing water washing with a freely-falling curtain-like liquid film. As shown in Fig. 1, the apparatus 10 for performing water washing with a freely-falling curtain-like liquid film includes a water storage tank 104 to store water 102, a water supply pipe 106 to supply water to the water storage tank 104, and a flow controlling unit 108 to supply a freely-falling curtain-like liquid film from the water storage tank 104 to an aluminum sheet 1.
In the apparatus 10, water 102 is supplied from the water supply pipe 106 to the water storage tank 104, and overflow of water 102 from the water storage tank 104 is controlled by the flow controlling unit 108 so that a freely-falling curtain-like liquid film is supplied to an aluminum sheet 1. The apparatus 10 is preferably used at a liquid flow rate of 10 to 100 L/minute. The distance L between the apparatus 10 and the aluminum 1, in which water 102 is present in the form of a freely-falling curtain-like liquid film, is preferably from 20 to 50 mm. The aluminum sheet preferably makes an angle α of 30 to 80° in the horizontal direction.

Using the apparatus that performs water washing with a freely-falling curtain-like liquid film as shown in Fig. 1 makes it possible to uniformly wash the aluminum sheet with water, so that the uniformity of the treatment performed before the water washing treatment can be improved.
A specific example of the apparatus that performs water washing with a freely-falling curtain-like liquid film preferably includes the apparatus described in JP-A No. 2003-96584.

The water washing treatment may also be performed using a spray tube such as a spray tube having, along the width direction of the aluminum sheet, spray tips for spreading water in the form of a folding fan.
Spray tips are preferably provided at intervals of 20 to 100 mm, and the liquid flow rate per spray tip is preferably from 0.5 to 20 L/minute. Two or more spray tubes are preferably used.

### Surface Roughening Treatment (Graining Treatment)

First, a description is given of the surface roughening treatment.
The aluminum sheet is grained to have a more preferred texture. The graining process may be mechanical graining as described in JP-A No. 56-28893 (mechanical surface roughening), chemical etching, electrolytic graining, or the like. Also used may be an electrochemical graining method (electrochemical surface roughening, electrolytic surface roughening) in which electrochemical graining is performed in a hydrochloric acid or nitric acid electrolyte; or a mechanical graining method (mechanical surface roughening) such as a wire brush graining method in which the aluminum surface is scratched with metal wires, a ball graining method in which the aluminum surface is grained with abrasive balls and an abrasive, or a brush graining method in which the surface is grained with a nylon brush and an abrasive. These graining methods may be used alone or in any combination. For example, a mechanical surface roughening treatment with a nylon brush and an abrasive may be used in combination with an electrolytic surface roughening treatment with a hydrochloric acid or nitric acid electrolyte, or a plurality of electrolytic surface roughening treatments may be used in combination. In particular, an electrochemical surface roughening treatment is preferred. A mechanical surface roughening treatment is also preferably performed in combination with an electrochemical surface roughening treatment, and in particular, a mechanical surface roughening treatment is preferably followed by an electrochemical surface roughening treatment.

### Mechanical Surface Roughening Treatment

The mechanical surface roughening treatment includes mechanically roughening the surface of the aluminum sheet with a brush or the like, which is preferably performed before the electrochemical surface roughening treatment.
In a preferred mode of the mechanical surface roughening treatment, the treatment is performed with a rotating nylon brush roll with a bristle diameter of 0.07 to 0.57 mm and an abrasive slurry liquid supplied to the surface of the aluminum sheet.

The nylon brush preferably has low water absorption rate and for example is preferably Nylon Bristle 200T (trade name) manufactured by TORAY INDUSTRIES, INC. (6,10-nylon; softening point 180°C; melting point 212 to 214°C; specific gravity 1.08 to 1.09; moisture content rate 1.4 to 1.8 at 20°C and a relative humidity of 65%, 2.2 to 2.8 at 20°C and a relative humidity of 100%; dry tensile strength 4.5 to 6 g/d; dry tensile elongation 20 to 35%; shrinkage after boiling water 1 to 4%; dry tensile resistance degree 39 to 45 g/d; Young modulus (dry) 380 to 440 kg/mm²).

Known abrasives may be used. For example, silica sand, quartz, aluminum hydroxide, or mixture thereof as described in JP-A No. 06-13 5175 and Japanese Patent Application Publication (JP-B) No. 50-40047 is preferably used as the abrasive.

The slurry liquid preferably has a specific gravity in the range of 1.05 to 1.3. Examples of methods for supplying the slurry liquid to the surface of the aluminum sheet include a method of spraying the slurry liquid, a method using a wire brush, and a method of transferring the roughened surface texture of a rolling mill roll to the aluminum sheet. The methods described in JP-A Nos. 55-74898, 61-162351 and 63-104889 may also be used. A method as described in Japanese Patent Application National Publication (Laid-Open) No. 09-509108 may also be used, in which the surface of the aluminum sheet is polished with a brush in an aqueous slurry containing a mixture of alumina and quartz particles in the weight ratio of 95:5 to 5:95. In this treatment, the mixture preferably has an average particle size of 1 to 40 µm, particularly preferably 1 to 20 µm.

### Electrochemical Surface Roughening Treatment

In contrast to the mechanical surface roughening treatment, the electrochemical surface roughening treatment electrochemically roughens the surface of the aluminum sheet with an alternating current through the aluminum sheet used as an electrode in an aqueous acid solution.

In an embodiment of the invention, the electrochemical surface roughening treatment may be performed in such a way that the Q_{c}/Q_{A} ratio is kept in the range of 0.5 to 2.0, wherein Q_{C} is the electric quantity at the time when the aluminum sheet serves as a cathode (cathodic electric quantity), and Q_{A} is the electric quantity at the time when it serves as an anode (anodic electric quantity), so that uniform honeycomb pits can be formed on the surface of the aluminum sheet. If Q_{C}/Q_{A} is less than 0.50, non-uniform honeycomb pits may be easily formed. If it is more than 2.0, non-uniform honeycomb pits may also be easily formed. Q_{C}/Q_{A} is preferably in the range of 0.8 to 1.5.

The waveform of the alternating current used in the electrochemical surface roughening treatment may be a sine wave, a rectangular wave, a triangular wave, a trapezoidal wave, or the like. In view of the cost of making the power source equipment, the frequency of the alternating current is preferably from 30 to 200 Hz, more preferably from 40 to 120 Hz, even more preferably from 50 to 60 Hz.

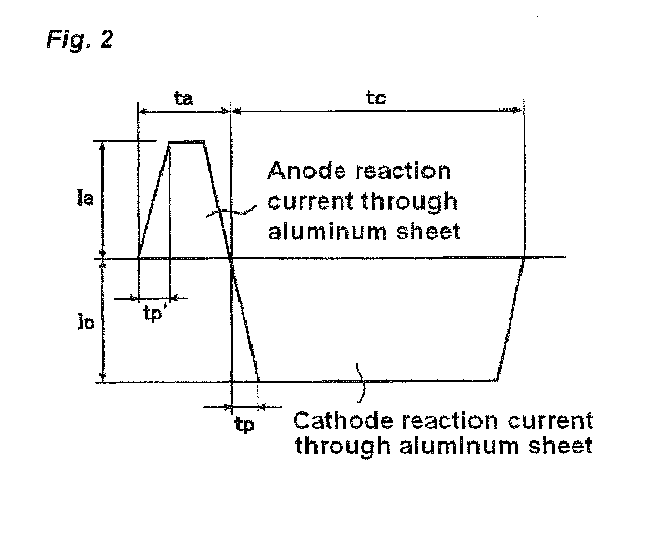

Fig. 2 shows an example of the trapezoidal wave suitable for use in an embodiment of the invention. In Fig. 2, the ordinate axis represents the current value, and the abscissa axis represents the time. In Fig. 2, ta represents the anodic reaction time, tc represents the cathodic reaction time, tp represents the time until the current value reaches a peak on the cathode cycle side from zero, tp' represents the time until the current value reaches a peak on the anode cycle side from zero, Ia represents the peak current on the anode cycle side, and Ic represents the peak current on the cathode cycle side. When a trapezoidal wave is used as the alternating current waveform, the times tp and tp' until the current reaches a peak from zero are each preferably from 0.1 to 2 msec, more preferably from 0.3 to 1.5 msec. If tp and tp' are less than 0.1 msec, the impedance of the power circuit may have a certain effect, so that a large source voltage may be necessary at the time of rise of the current waveform, which may increase the cost of the power supply system. Iftp and tp' are more than 2 msec, the trace components in the aqueous acid solution may have a significant effect, so that uniform surface roughening may be difficult.

In order to uniformly roughen the surface of the aluminum sheet, the duty of the alternating current used in the electrochemical surface roughening treatment is preferably in the range of 0.25 to 0.75, more preferably in the range of 0.4 to 0.6. As used herein, the term "duty" refers to the ratio ta/T, wherein T is the period of the alternating current, and ta is the time for which the anodic reaction of the aluminum sheet continues (anodic reaction time). Particularly during the cathodic reaction time, not only a smut component mainly composed of aluminum hydroxide is produced on the surface of the aluminum sheet, but also the oxide film is dissolved or destroyed, so that a start point is provided for a pitting reaction in the anodic reaction of the aluminum sheet. Therefore, the selected duty of the alternating current may have a significant effect on uniform surface roughening.

In the case of a trapezoidal or rectangular wave, the current density of the alternating current is preferably such that the peak current density Iap on the anode cycle side and the peak current density Icp on the cathode cycle side are each from 10 to 200 A/dm². Icp/Iap is preferably in the range of 0.9 to 1.5.

In the electrochemical surface roughening treatment, the total electric quantity used in the anodic reaction of the aluminum sheet is preferably from 50 to 1,000 C/dm² at the time of the completion of the electrochemical surface roughening treatment. The time of the electrochemical surface roughening treatment is preferably from 1 second to 30 minutes.

Aqueous acid solutions for use in ordinary electrochemical surface roughening treatments using a direct or alternating current may be used in the electrochemical surface roughening treatment. In particular, an aqueous acid solution mainly composed of nitric or hydrochloric acid is preferably used. As used herein, the term "mainly composed of" means that the content of the primary component in the aqueous solution is 30% by weight or higher, preferably 50% by weight or higher, based on the total amount of all the components. The same applies to other components.

As mentioned above, an aqueous acid solution mainly composed of nitric acid, for use in general electrochemical surface roughening treatments using a direct or alternating current, may be used. For example, at least one kind of nitrate compound such as aluminum nitrate, sodium nitrate or ammonium nitrate may be added at a concentration of 0.01 g/L to saturation to an aqueous nitric acid solution with a nitric acid concentration of 5 to 15 g/L, and the resulting solution may be used. A certain metal contained in the aluminum alloy, such as iron, copper, manganese, nickel, titanium, magnesium, or silicon may be dissolved in the aqueous acid solution mainly composed of nitric acid.

In particular, an aqueous acid solution mainly composed of nitric acid, which is preferably used, may contain nitric acid, an aluminum salt, and a nitrate and be obtained by adding, to an aqueous nitric acid solution with a nitric acid concentration of 5 to 15 g/L, aluminum nitrate and ammonium nitrate in such a manner that the aluminum ion concentration can be from 1 to 15 g/L, preferably from 1 to 10 g/L and that the ammonium ion concentration can be from 10 to 300 ppm. The aluminum ions and the ammonium ions spontaneously increase during the electrochemical surface roughening treatment. In this treatment, the liquid temperature is preferably from 10 to 95°C, more preferably from 20 to 90°C, particularly preferably from 30 to 70°C.

The electrochemical surface roughening treatment may be performed using a known electrolytic apparatus such as a vertical type, a flat type, or a radial type. A radial type electrolytic apparatus as described in JP-A No. 05-195300 is particularly preferred.

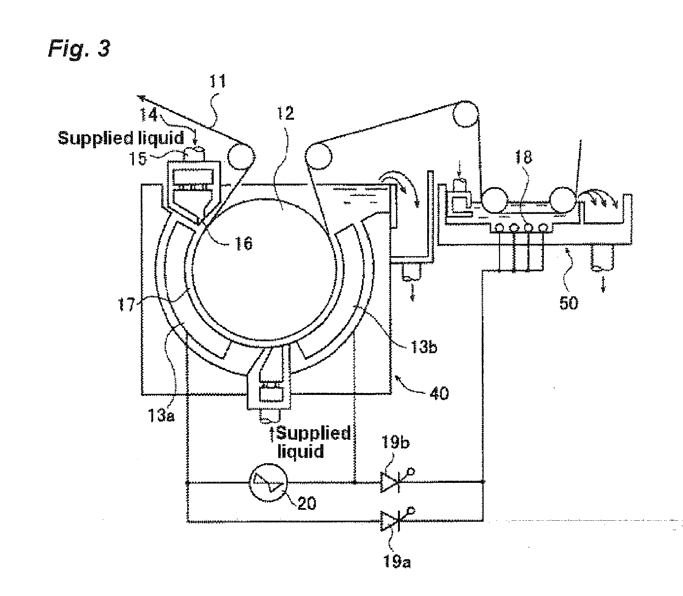

Fig. 3 is a schematic diagram of a radial type electrolytic apparatus suitable for use in an embodiment of the invention. In the radial type electrolytic apparatus shown in Fig. 3, an aluminum sheet 11 is wound on a radial drum roller 12 placed in a main electrolytic bath 40 and electrolyzed with main electrodes 13a and 13b connected to an AC power source 20 during the course of feeding. An aqueous acid solution (electrolytic treatment liquid) 14 is supplied from a solution (electrolyte) supply port 15 to a solution (electrolyte) passage 17 between the radial drum roller 12 and the main electrodes 13a and 13b through a slit 16.

The aluminum sheet 11 treated in the main electrolytic bath 40 is then electrolyzed in an auxiliary anode bath 50. In the auxiliary anode bath 50, auxiliary anodes 18 are placed opposite to the aluminum sheet 11, and the aqueous acid solution 14 is supplied so as to flow between the aluminum sheet 11 and the auxiliary anodes 18. The current through the auxiliary electrodes is controlled using thyristors 19a and 13b. The auxiliary anode bath 50 may be located before, behind or before and behind the main electrolytic bath 40.

The main electrodes 13a and 13b may be each selected from a carbon electrode, a platinum electrode, a titanium electrode, a niobium electrode, a zirconium electrode, a stainless steel electrode, electrodes for fuel cell cathodes, and so on. Carbon electrodes are particularly preferred. Common commercially available impervious graphite for chemical equipment, resin-impregnated graphite or the like may be used for the carbon electrode.

The auxiliary electrode 18 may be selected from known electrodes for oxygen generation, such as a ferrite electrode, an iridium oxide electrode, a platinum electrode, and an electrode of a valve metal (such as titanium, niobium or zirconium) cladded or plated with platinum.

The aqueous acid solution passing through the main electrolytic bath 40 and the auxiliary anode bath 50 may be supplied in a direction parallel or counter to the feeding direction of the aluminum sheet 11. The flow rate of the aqueous acid solution relative to the aluminum sheet is preferably from 10 to 5,000 cm/second.

One or more AC power sources may be connected to one electrolytic apparatus. Two or more electrolytic apparatuses may be used, in which the electrolytic conditions for the respective apparatuses may be the same or different.

After the electrolytic treatment is completed, liquid draining with a nip roller and water washing with a spray are preferably performed so that contamination of the following process with the treatment liquid can be prevented.

The process using the electrolytic apparatus preferably includes: adding nitric acid and water, while controlling the amount of the addition of nitric acid and water, based on the concentrations of nitric acid and aluminum ions determined from, for example, (i) the conductivity of the aqueous acid solution, (ii) the propagation velocity of ultrasonic wave, and (iii) the temperature, in proportion to the amount of the current through the aqueous acid solution with which the aluminum sheet causes the anodic reaction in the electrolytic apparatus; and discharging the same volume of the aqueous acid solution as the volume of the added nitric acid and water by successively allowing it to overflow from the electrolytic apparatus so that the concentration of the aqueous acid solution can be kept constant.

### Surface Treatments

Next, surface treatments such as a chemical etching treatment in an aqueous acid or alkali solution and a desmutting treatment are described one by one. The surface treatment may be performed before the electrochemical surface roughening treatment or after the electrochemical surface roughening treatment and before the anodizing treatment described below. The description of each surface treatment below is only illustrative and not intended to limit the scope of the invention. The surface treatment or each treatment described below may be performed as needed.

### Alkali Etching Treatment

The alkali etching treatment includes chemically etching the surface of the aluminum sheet in an aqueous alkali solution, which is preferably performed before and after the electrochemical surface roughening treatment. When the mechanical surface roughening treatment is performed before the electrochemical surface roughening treatment, the alkali etching treatment is preferably performed after the mechanical surface roughening treatment. The alkali etching treatment can destroy the fine structure in a short time and therefore is more advantageous than the acid etching treatment described below.

The aqueous alkali solution for use in the alkali etching treatment may be an aqueous solution containing one or two or more of sodium hydroxide, sodium carbonate, sodium aluminate, sodium metasilicate, sodium phosphate, potassium hydroxide, and lithium hydroxide. A sodium hydroxide (caustic soda)-based aqueous solution is particularly preferred. The aqueous alkali solution may contain 0.5 to 10% by weight of alloy component of the aluminum sheet as well as aluminum.

The concentration of the aqueous alkali solution is preferably from 1 to 50% by weight, more preferably from 1 to 30% by weight.

The alkali etching treatment is preferably performed at an aqueous alkali solution temperature of 20 to 100°C, more preferably 40 to 80°C, for a treatment time of 1 to 120 seconds, more preferably 2 to 60 seconds. The amount of dissolution of aluminum is preferably from 5 to 20 g/m² after the mechanical surface roughening treatment and preferably from 0.01 to 10 g/m² after the electrochemical surface roughening treatment. When a chemical etching liquid is fist mixed in an aqueous alkali solution, the treatment liquid is preferably prepared using liquid sodium hydroxide (caustic soda) and sodium aluminate.

After the alkali etching treatment is completed, liquid draining with a nip roller and water washing with a spray are preferably performed so that contamination of the following process with the treatment liquid can be prevented

When the alkali etching treatment is performed after the electrochemical surface roughening treatment, the smut produced by the electrochemical surface roughening treatment can be removed by the etching treatment. Preferred examples of such a alkali etching treatment include a method of contacting with 15 to 65% by weight sulfuric acid at a temperature of 50 to 90°C as described in JP-A No. 53-12739 and an alkali etching method as described in JP-B No. 48-28123.

### Acid Etching Treatment

The acid etching treatment includes chemically etching the aluminum sheet in an aqueous acid solution, which is preferably performed after the electrochemically surface roughening treatment. When the alkali etching treatment is performed before and/or after the electrochemical surface roughening treatment, the acid etching treatment is preferably performed after the alkali etching treatment.

When the acid etching treatment is performed after the alkali etching treatment is performed on the aluminum sheet, intermetallic compounds including silica or simple Si can be removed from the surface of the aluminum sheet, so that a defect-free anodic oxidation film can be produced by the subsequent anodizing treatment. As a result, an increase in leakage current can be prevented, and sufficient insulation can be maintained.

The aqueous acid solution for use in the acid etching treatment may be an aqueous solution containing phosphoric acid, nitric acid, sulfuric acid, chromic acid, hydrochloric acid, or a mixed acid of two or more thereof In particular, an aqueous sulfuric acid solution is preferred. The concentration of the aqueous acid solution is preferably from 50 to 500 g/L. The aqueous acid solution may contain any alloy component of the aluminum sheet as well as aluminum.

The acid etching treatment is performed at a liquid temperature of 60 to 90°C, preferably 70 to 80°C, for a treatment time of 1 to 10 seconds. In this process, the amount of dissolution of the aluminum sheet is preferably from 0.001 to 0.2 g/m². The acid concentration such as the concentration of sulfuric acid; and the concentration of aluminum ions are preferably selected in the range where crystallization does not occur at ordinary temperature. The aluminum ion concentration is preferably from 0.1 to 50 g/L, particularly preferably from 5 to 15 g/L.

After the acid etching treatment is completed, liquid draining with a nip roller and water washing with a spray are preferably performed so that contamination of the following process with the treatment liquid can be prevented.

### Desmutting Treatment

When the alkali etching treatment is performed before and/or after the electrochemical surface roughening treatment, smut is generally produced on the surface of the aluminum sheet by the alkali etching treatment. In this case, therefore, the process of dissolving the smut (so-called desmutting) is preferably performed in an acid solution containing phosphoric acid, nitric acid, sulfuric acid, chromic acid, hydrochloric acid, hydrofluoric acid, fluoroboric acid, or a mixed acid of two or more thereof, after the alkali etching treatment. After the alkali etching treatment, it is enough to perform any one of the acid etching treatment and the desmutting treatment.

The concentration of the acid solution is preferably from 1 to 500 g/L. The acid solution may contain 0.001 to 50 g/L of any alloy component of the aluminum sheet as well as aluminium.
The temperature of the acid solution is preferably from 20 to 95°C, more preferably from 30 to 70°C. The treatment time is preferably from 1 to 120 seconds, more preferably from 2 to 60 seconds.

The waste of the aqueous acid solution used in the electrochemical surface roughening treatment is preferably used as the desmutting treatment liquid (acid solution), so that the amount of the liquid waster can be reduced.
After the desmutting treatment is completed, liquid draining with a nip roller and water washing with a spray are preferably performed so that contamination of the following process with the treatment liquid can be prevented.

### Polishing Process

Particularly when the plane roughness is desired to be small, at least a mechanical polishing process should be performed among various known metal surface treatment methods for removing relatively large asperities such as "blisters" and "rolling stripes." The mechanical polishing process is preferably followed by an auxiliary process such as a chemical polishing process or an electrochemical polishing process. The polishing method disclosed in JP-A No. 2007-30146 may be used.

When the surface roughness of the anodic oxidation layer is reduced by the process described below, the mechanical process makes it possible to obtain an aluminum sheet with an arithmetic mean roughness Ra of 0.1 µm or less and a surface glossiness of 60% or higher.

### Arithmetic Mean Roughness Ra

In general, the arithmetic mean roughness Ra of a metal surface is determined by a process including measuring the roughness of each of portions each having a standard length in the rolling direction and located in the transverse direction perpendicular to the rolling direction, and averaging the measurements. In an embodiment of the invention, the surface roughness is preferably determined by a profile curve method in which the contour of a cross section perpendicular to the surface of the object is determined, and the profile curve is preferably obtained using a contact-probe profilometer for an Ra of 1 µm or more or using an atomic force microscope (AFM) to measure the atomic force for an Ra of less than 1 µm. According to JIS B 601 (1994), a continuous part only with a standard length L is sampled from the roughness curve with respect to each of plural portions (for example, five portions), and the roughness of the sampled part is evaluated with respect to the length to be evaluated. The standard length may be the same as the cut-off value. Within the range of each standard length, various roughness parameters are determined, and the results are averaged with respect to the total number of the standard length portions. The average is used as a measurement. In an embodiment of the invention, the mean surface roughness may be the average of the measurements in the rolling direction and the direction perpendicular to the rolling direction.

### Surface Glossiness

According JIS Z 8741, the surface of glass having a refractive index of 1.567 over the visible wavelength range (a specular reflectivity of 10% at an incidence angle of 60°) is defined as having a glossiness of 100 (%). However, the surface of glass with a refractive index of 1.567 is susceptible to erosion from moisture. Therefore, a glass surface with a refractive index of about 1.500 (a glossiness of 90%) may be used as a practical standard surface (the absolute value may be corrected every time so that the glossiness of the standard plate can be 90%).

When the glossiness of the surface of common materials is measured, a high glossiness should be measured at a small angle, while a low glossiness should be measured at a large angle. According to JIS, the angle is set to 20°, 45°, 60°, 75°, or 85°. In practice, however, a 60° gloss meter is often used, because of its wide measurement range. This is because the glossiness can be proportional to the angle, and therefore, even if not all the angles are used, the measurement at an angle allows estimation of the glossiness at another angle. According to JIS, the glossiness may be defined by percentage (%) or numerical value.

The glossiness is also called regular reflectance, which may be determined by a process including measuring plural portions in each of the longitudinal direction (parallel to the rolling direction) and the transverse direction (perpendicular to the rolling direction) and averaging the measurements in each direction. The aluminum substrate for use in an embodiment of the invention may have a glossiness of 60% or higher, preferably 80% or higher, in each of the longitudinal and transverse directions.

In an embodiment of the invention, the average glossiness in each of the longitudinal direction and the transverse direction is preferably determined with respect to an area of 50 mm² or more, more preferably 400 mm² or more, even more preferably 900 mm² or more.

The aluminum substrate surface with an arithmetic mean roughness Ra of 0.1 µm or less and a surface glossiness of 60% or higher is considered to be substantially specular and free of visible scratches.

### Mechanical Polishing

Mechanical polishing is a polishing technique including embedding an abrasive-containing material such as a slurry of a mixture of water and an abrasive in a support material such as a cloth, a paper sheet or a metal or supplying the abrasive-containing material to between the substrate to be polished and the polishing support material; and allowing them to rub against each other so that the substrate is polished with sharp portions of the abrasive. This technique allows mechanical treatment of a large area, delivers high grinding performance and is capable of removing deep scratches. Generally when the substrate is a thin sheet, it should be embedded in a resin material or attached to a metal block so that it can be formed into a shape susceptible to polishing. Particularly for mirror finish, it is called buffing, in which the polishing cloth and the abrasive are characteristic.

### (1) Fine Polishing

A waterproof paper sheet or cloth coated with an abrasive such as SiC, diamond or alumina particles is preferably used as a polishing material. Particles with a particle size of about #80 (200 µm) to #4000 (4 µm) may be used. Examples of polishing materials include an abrasive paper sheet composed of waterproof paper and SiC powder embedded therein, a fine grinder composed of a metal and diamond powder embedded therein, and a napped fabric (generally called buff) for use in combination with a slurry or paste including a mixture of an abrasive and water or chemicals.

Abrasives or polishing cloths are preferably used in the order of small number (large particle size) to large number (small particle size) stepwise. Buffing may be performed with a coarse abrasive without performing fine polishing. However, any residual of the course abrasive may cause scratches, and, therefore, it is preferred to perform fine polishing with an abrasive-coated waterproof paper sheet or cloth. The waterproof paper sheet or cloth is preferably changed for every abrasive. Specific examples: Polishing Cloth DP-Net (product name), manufactured by Marumoto Struers K.K., 6 µm to 45 µm in particle size (various types); Polishing Cloth DP-Nap (product name), manufactured by Marumoto Struers K.K., 0.25 µm to 1 µm in particle size (various types); and Waterproof Abrasive Paper #80 to #1500 (product name), manufactured by Marumoto Struers K.K. (various types).

### (2) Buffing

Buffing is a technique including providing a buff based on such a material as a cotton cloth, a sisal linen cloth, or wool fibers; rotating, at high speed, the buff with an abrasive bonded to the circumference surface with an adhesive (such as glue) or rotating the buff at high speed, while an abrasive is temporarily held on the surface of the rotating buff; and pressing a workpiece against the rotating surface to polish the material surface so that a uniform surface can be obtained.

### (a) Polishing Machine

A buffing machine is a polishing machine that performs working with a buff attached to the end of the shaft and rotating at high speed and with an abrasive held on the circumference surface of the buff. Various commercially-available polishing machines may be used, known examples of which include LaboPol-5 (trade name), RotoPol-35 (trade name) and MAPS (trade name) all manufactured by Marumoto Struers K.K.
Polishing may be performed manually or automatically using a tool as needed.

### (b) Buffs

Examples of buffs include cloth buffs such as sewn buffs, stitched buffs, loose buffs, bias buffs, and sisal buffs; and other buffs such as flap wheels, nonwoven wheels, and wire wheels. These buffs may be used depending on the intended use. Napped cotton buffs are preferred. Specific examples: product names, Polishing Cloth Nos. 101 (wool), 102 (cotton), 103 (synthetic fibers), and 773 (a blend of cotton and synthetic fibers), manufactured by Marumoto Struers K.K.

### (c) Abrasive

The term "buffing abrasive" refers to an abrasive material that contains relatively fine abrasive particles as a primary component and is prepared by homogeneously mixing the particles with a medium composed of grease and other suitable components. Specific Example: Waterproof Abrasive Paper #80 to #1500 (product name), manufactured by Marumoto Struers K.K. (various types).

### (c-1) Grease-Based Abrasive

The term "grease-based abrasive" refers to an abrasive produced by kneading fine abrasive particles with grease and solidifying the resulting mixture, which is mainly used for mid-stage polishing or finish polishing in a buffing process. The greases commonly used include stearic acid, paraffin, tallow, and rosin. When the grease-based abrasive is pressed against a buff, the grease is molten by the frictional heat, so that the abrasive particles move to the buff surface along with the grease. When a metal article is pressed against the buff, the grease forms an oil film on the surface of the metal, so that unnecessary biting of the abrasive particles into the metal surface is prevented, which serves to smooth the metal surface. Examples of the grease-based abrasive include emery paste, tripoli, gloss, lime, green rouge, red rouge, white rouge, and grease stick. Particularly preferred are tripoli (primary component, SiO₂; Mohs hardness, 7), machiless (phonetic) (primary component, CaO; Mohs hardness, 2), green rouge (primary component, Cr₂O₃; Mohs hardness, 6), and white rouge (primary component, Al₂O₃; Mohs hardness, 9).

### (c-2) Liquid abrasive

A liquid abrasive is an abrasive produced for use in an automatic buffing machine and produced in the form of a liquid for automatic supply to the buffing machine. A method includes spraying the abrasive from a spray gun and controlling the opening/closing of the nozzle of the spray gun in response to the operation of a timer so that the abrasive can be intermittently sprayed. Known examples include liquid abrasives containing SiC, diamond, or alumina powder. The particle size of relatively coarse abrasives separable by sieving is generally indicated by grit number, and the higher the grit number, the smaller the average particle size.

**[Table1]**

| | | | | | | | | | | |
|---|---|---|---|---|---|---|---|---|---|---|
| **Grit number (Grit #)** | 80 | 240 | 400 | 800 | 1000 | 1500 | 2000 | 3000 | 4000 | 8000 |
| **Average particle size** [µm] | 300 | 80 | 40 | 20 | 16 | 10 | 7.9 | 5 | 4.5 ∼ 3.1 | 2 ∼ 1.5 |

Polishing is generally performed using abrasives in the order of coarse size to fine size. Specular gloss starts to appear, when the grit number of the abrasive reaches about #1,000m, and a visually specular state is achieved by polishing with an abrasive with a grit number of about #1,500 or more.
Various types of abrasives with average particle sizes of about 0.1 µm to about 100 µm are commercially available, specific examples of which include the products shown below.
Diamond Suspension DP-Spray (product name), manufactured by Marumoto Struers K.K., 0.25 µm to 45 µm in particle size (various types); Alumina Suspension Nos. 100 (1 µm in particle size) to 2000 (0.06 µm in particle size) (product name), manufactured by Meller (various types).

### (c-3) Polishing Aid

Emery may be bonded to a cloth buff with glue, cement, or the like. Glue forms a viscous liquid when dissolved in hot water. Cement is prepared by mixing a synthetic resin with sodium silicate and used to bond emery to a buff similarly to glue.

Specific examples of methods for removing large and deep asperities (several hundred micrometers to several millimeters) are shown below. The peripheral speed is preferably in the range of 1,800 to 2,400 m/minute.

**[Table 2]**

| Polishing tool type | Form | Abrasive type | Grit | Polishing material | Ra (µm) after polishing |
|---|---|---|---|---|---|
| Polishing cloth or paper | Sheet | Garnet Alumina Zirconia SiC | #10000∼80 | Cloth | 2∼0.1 |
| Polishing film | Sheet | Alumina SiC Diamond | #10000∼500 | PET | 1.5∼0.1 |
| Flap wheel | Wheel | Alumina SiC | #1000∼500 | Cloth | 1.5∼0.3 |
| Polishing brush | Wheel Roll etc. | Alumina SiC | #3000∼100 | Nylon Aramid | 1.5∼0.2 |
| PVA grinder | Wheel Roll etc. | Alumina | #10000∼3000 | Cloth | 0.1∼0.3 |
| Buff | Wheel Rotating sheet | Alumina | #10000∼3000 | Napped cloth | 0.1∼0.3 |

In particular, an abrasive cloth or paper and a buff are preferred in view of availability and versatility.
All the polishing processes may be performed with buffs. In such a case, it is preferred that rough polishing (with grit of #400 or less) be performed with a sisal linen cloth or a cotton twill, mid-stage polishing (with a grit of #400 to #1000) with a plain weave cotton or rayon cloth, and finish polishing (with a grit of #1000 or more) with a calico, broadcloth, flannel, felt, oxhide, or the like. When the grit number is changed, the cloth should be replaced by a new one, and the polished surface be fully cleaned beforehand.
A detailed description is given in "New Practical Technology for Polishing" published by Ohmsha, Ltd., 1992, 1st edition, pages 55 to 93.

Electrolytic-abrasive polishing may also be used in place of the mechanical polishing described above.
Electrolytic-Abrasive Polishing
Electrolytic-abrasive polishing is a working method including applying a direct current at a current density of preferably 0.05 to 1 A/cm², more preferably in the order of 0.1 A/cm², to a workpiece, while abrasively polishing the workpiece under a pressing pressure of 5 to 20 kPa (50 to 200 g/cm²). In general electrolysis at such a current density, a thick passive film is formed on the surface of the workpiece, so that metal is hardly dissolved, and therefore the process does not proceed. Once the passive film is removed by the friction of the abrasive, however, metal is significantly dissolved from the exposed portion, so that the current efficiency rapidly increases to a level of tens to 100%. Thus, the amount of the electro-dissolution is rapidly increased by selective abrasion of micro projections by the abrasive grains, while the amount of processing of the recessed portions is close to zero, so that the surface roughness is rapidly reduced.

Not only general abrasives but also colloidal silica or colloidal alumina may be preferably used. Specifically, high purity colloidal silica PL series manufactured by Fuso Chemical Co., Ltd. may be used, such as PL-1 (primary particle size, 15 nm; secondary particle size, 40 nm), PL-3 (primary particle size, 35 nm; secondary particle size, 70 nm), PL-7 (primary particle size, 70 nm; secondary particle size, 120 nm), and PL-20 (primary particle size, 220 nm; secondary particle size, 370 nm) (all trade names). In addition, PLANERLITE (trade name) series manufactured by Fujimi Incorporated may also preferably be used.

### (1) Oscar-Type Polishing Machine

When not only a certain specular rate but also a certain flatness have to be ensured, an Oscar-type polishing machine should preferably be used. An Oscar-type polishing machine, which has been used to polish optical components and so on, has such a structure that the workpiece is rotated in connection with the rotation of the tool surface plate, so that the amount of processing hardly varies with the position and that high form accuracy is easily obtained. On the other hand, electrolytic-abrasive polishing is **characterized in that** it can efficiently reduce the surface roughness. Therefore, a combination of them can achieve high-precision, high-quality mirror finish.

More specifically, electrolytic-abrasive polishing as described in Japanese Patent No. 3044377 or 3082040 may be used.
More specifically, the method described in the text "New Practical Technology for Polishing," published by Ohmsha, Ltd., 1992, 1 st edition, pages 55 to 93 may also be used.

### Chemical Polishing and Electrochemical Polishing

In the process of manufacturing the aluminum substrate for use in an embodiment of the invention, the mechanical polishing is preferably followed by chemical polishing or electrochemical polishing as auxiliary means. As used herein, the term "auxiliary means" means that polishing is performed at a rate of change of 50% or lower of the rate of Ra change obtained by mechanical polishing.

### (1) Chemical Polishing Treatment

Chemical polishing treatment may be a process including immersing the aluminum in an aqueous alkaline or acid solution to dissolve its surface. An aqueous alkali solution containing sodium carbonate, sodium silicate, or sodium phosphate alone as a primary component or an aqueous solution of any mixture thereof is preferably used. An aqueous acid solution of sulfuric acid, nitric acid, phosphoric acid, or butyric acid alone or an aqueous solution of any mixture thereof may be used.
After the mechanical polishing treatment, chemical polishing is preferably used as auxiliary means. Some examples are shown in the table below.

**[Table3]**

| **Kind of solution (Mass %)** | **Temperature** | pH | **Time** |
|---|---|---|---|
| 0.5 to 2% Sodium carbonate 0.05 to 0.2% Silicate | Room temperature to 5 0°C | 9 to 12 | 10 sec. to 30 min. |
| 0.5 to 4% Sodium metasilicate | Room temperature to 70°C | 9 to 12 | 10 sec. to 30 min. |
| 0.6 to 1.8% Sodium carbonate 0.6% Sodium orthophosphate | 5 0 to 7 0°C | 9 to 1 2 | 10 sec. to 3 0 min. |
| 0.1 to 0.5% Sodium carbonate 0.6 to 1.2% Sodium silicate | 50 to 70°C | 9 to 12 | 10 sec. to 3 0 min. |

When the composition is appropriately controlled as shown above, the aluminum substrate can be gradually dissolved so that the mean surface roughness (Ra) can be reduced. Preferred specific examples of the aqueous acid solution are also shown below.

**[Table4]**

| Kind of solution (Mass %) | Temperature | pH | **Time** |
|---|---|---|---|
| 3 to 5% Sulfuric acid | Room temperature | 1 to 0. 3 | 1 to 5 min. |
| 1 to 3% Nitric acid | Room temperature | 2 to 0. 6 | 1 to 5 min. |
| 4% chromic acid 21 % Sulfuric acid | 60°C | -1 | 1 to 5 min. |
| 5% Hydrofluoric acid 2.5% Nitric acid | Room temperature | 0 | 30 sec. to 3 min. |

Also preferred is an aqueous solution of a mixture of sulfuric acid, nitric acid, phosphoric acid, and butyric acid in the composition shown in Table 3 of the text "Surface Treatment of Aluminum," published by Uchida Rokakuho Publishing Co., Ltd., 1980, 8th edition, page 36. The Alupol method described in Met. Ind., 78 (1951), 89, in which copper nitrate is added to a liquid mixture of concentrated phosphoric acid and fuming nitric acid, is also a preferred example.
Various methods as described in Table 5.2.17 of "Handbook of Aluminum Technology" (edited by Japan Light Metals Association and published by Kallos Publishing Co., Ltd., 1996) may also be used. In particular, the phosphoric acid-nitric acid method is preferred.

### (2) Electrochemical Polishing Treatment

Electrochemical polishing treatment is a process including dissolving and removing surface asperities from the aluminum sheet in an electrolyte, while generally applying a direct current. Preferred examples of the electrolyte include aqueous acid solutions of hydrogen peroxide, glacial butyric acid, phosphoric acid, sulfuric acid, nitric acid, chromic acid, or sodium dichromate alone, or aqueous acid solutions of any mixture thereof. In addition, ethylene glycol monoethyl ether, ethylene glycol monobutyl ester, or glycerin may also be used as an additive. Such an additive is effective in stabilizing the electrolyte and extending the range where the electrolysis can be properly performed against the concentration change, the change over time, or the degradation during use.

### (3) Electrolytic Polishing

After the mechanical polishing treatment, electrolytic polishing is preferably used as auxiliary means. Preferred examples of the electrolysis conditions are shown in the table below.

**[Table5]**

| **Electrolyte** | Temperature | Time, min. | Wave form | VoltageV | Current A/dm² |
|---|---|---|---|---|---|
| 15 to 25% Aqueous solution of perchloric acid (Specific gravity 1.48) 70 to 80% Glacial butyric acid | 50 °C or less | 10 to 20 | Direct current | 50 to 100 | 3 to 5 |
| 40 to 60 vol% Phosphoric acid 5 to 30 vol% Sulfuric acid 15 to 20 vol% Water 0 to 35 vol% Ethylene glycol monoethyl ether | 40 to 70°C | 3 to 10 | Direct current | 10 to 30 | 3 to 60 |

Also preferred are the polishing conditions shown in Table 6 of the text "Surface Treatment of Aluminum," published by Uchida Rokakuho Publishing Co., Ltd., 1980, 8th edition, page 47. Various methods as described in Table 5.2.17 of "Handbook of Aluminum Technology" (edited by Japan Light Metals Association and published by Kallos Publishing Co., Ltd., 1996) may also be used.
In view of availability and safety of the solution to be used, the Battelle method (see British Patent No. 526854 (1940) or British Patent No. 552638 (1943)) or the phosphoric acid bath method (see Japanese Patent No. 128891 (filed in 1935, JP-B No. 13-004757)) is preferred.

### Finish Polishing

The process of manufacturing the aluminum substrate for use in an embodiment of the invention preferably includes performing mechanical polishing, then performing chemical polishing and/or electrolytic polishing as auxiliary means, and then performing CMP (chemical mechanical polishing) or barrier film removing method as auxiliary means.

### (1) CMP Method

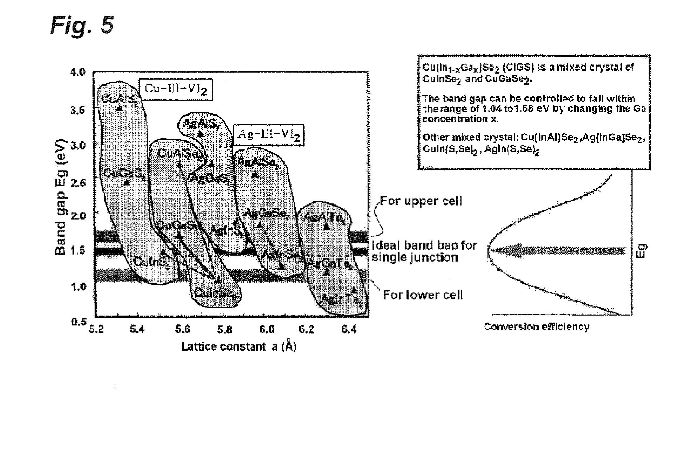

The CMP method is a combination of mechanical polishing and chemical polishing, which is generally used in semiconductor processes. It may also be used to polish the aluminum substrate, as long as the aluminum substrate has been sufficiently polished to have a flat mirror surface. Alumina or silica slurry is generally used in polishing metal such as aluminum. Colloidal alumina or colloidal silica may be used, examples of which include high purity colloidal silica PL series manufactured by Fuso Chemical Co., Ltd. and PLANERLITE series manufactured by Fujimi Incorporated (all trade names). An appropriate amount of H₂O₂, Fe(NO₃)₂ or KIO₃ may also be added as an additive. In order to prevent scratches or burying of the abrasive, the metal surface has to be oxidized by the additive during the polishing. Therefore, an acidic slurry having a controlled pH of 2 to 4 is generally preferred. The abrasive preferably has a primary particle size in the range of 5 nm to 2 µm, and the slurry concentration is preferably in the range of 2 to 10 vol%. In order to prevent scratches, soft CMP pads are preferably used. Examples include CAMP pads XHGM-1155 and XHGM-1167 (all trade names) manufactured by Rodel Nitta.
Also use may be methods described in the text: Kazuo Maeda, "Introduction of Semiconductor Manufacturing Equipment," published by Kogyo Chosakai Publishing Co., Ltd. March, 1999 (page 171, Fig. 5.44, "Basic Principle of CMP Method and Apparatus Structure" and page 172, Fig. 5.45, Structure of CMP Apparatus).
The CMP method allows high-precision polishing but requires expensive equipment and complicated selection of the abrasive or the additive or complicated setting of polishing conditions. Alternatively, therefore, a barrier film removing method may be used for finish polishing.

### (2) Barrier Film Removing Method

After the chemical polishing treatment or the electrolytic polishing treatment, a barrier film removing method is preferably performed for further smoothing. In this method, a micropore-free barrier-type anodic oxidation film is formed and then removed.
The process of forming a barrier film may generally include performing electrolysis in a nearly-neutral electrolyte with a pH of about 4 to about 8 so that a micropore-free uniform oxide film can be formed. Specific examples of electrolysis conditions are shown below. An aqueous solution of a neutral salt such as borate, adipate, phosphate, citrate, tartrate, oxalate or mixture thereof is preferably used. More specifically, an aqueous boric acid-sodium borate mixture solution, an ammonium tartrate solution, a citric acid solution, a maleic acid solution, a glycolic acid solution, or the like may be used.

More specifically, the electrolysis conditions shown in the table below are preferred. It is known that a micropore-free oxide film is produced by anodic oxidation with such electrolytic solutions. The voltage is preferably in the range of 10 V to 800 V, more preferably 30 V to 500 V. The pH is preferably in the range of 4 to 8, more preferably 5 to 7.
In a preferred range of the electrolysis time, constant current electrolysis is preferably terminated before the voltage is saturated, or constant voltage electrolysis is preferably terminated before there is almost no current flow. The electrolysis time is preferably in the range of 1 to 30 minutes, more preferably 1 to 12 minutes.

**[Table6]**

| Electrolyte | Temperature | Time, sec. | Wave form | VoltageV | Current A/dm² |
|---|---|---|---|---|---|
| 0.5mol/L Boric acid | 20 to 90°C | 300 to 1200 | Direct current | 0 to 1200 | 2 5 |
| 0.5mol/L Boric acid /0.0005 to 0.05 mol/L Sodium borate | 20 to 90°C | 3 0 0 to 1200 | Direct current | 0 to 1200 | 2 5 |
| 2 mol/L Boric acid /0.005mol/L Ammonium pentaborate | 20 to 90°C | 300 to 1200 | Direct current | 0 to 1200 | 2 5 |
| 150g/L Ammonium adipate | 20 to 90°C | 300 to 1200 | Direct current | 0 to 110 | 2 5 |
| 1.4g/L Ammonium dihydrogen phosphate | 20 to 90 °C | 300 to 1200 | Direct current | 0 to 110 | 2 5 |

**[Table7]**

| Kind of electrolyte | Concentration | pH | Temperature | Voltage | Thickness of film | Preferred electrolysis time |
|---|---|---|---|---|---|---|
| Ammonium tartrate | 0.27mol/L | 6.7 | 33°C | 100 V | 0.15 µ m | 1.5 min to 10 min. |
| Ammonium tartrate | 0.27mol/L | 6.7 | 33°C | 200 V | 0.3µm | 3 min. to 20 min. |
| Ammonium tartrate | 0.1mol/L | 6.7 | 33°C | 300V | 0.4µm | 4 min to 30 min. |
| Ammonium tartrate | 0.1mol/L | 6.7 | 33°C | 400V | 0.5µm | 5 min. to 40 min. |
| Ammonium tartrate | 0.1mol/L | 6.7 | 33°C | 500V | 0.6µm | 6 min. to 60 min. |
| Boric acid-Sodium borate | 0.05mol/L-0.5mol/L | 4.5 | 20°C | 100V | 0.1µM | 1.5 min. to 10 min. |

The barrier film is generally removed using a mixture of aqueous acidic solutions such as aqueous solutions of phosphoric acid, chromic acid, nitric acid, and sulfuric acid. An aqueous chemical polishing solution or an aqueous solution of chromic acid and phosphoric acid is preferably used.
It is known that the barrier film is generally formed thick at projections and thin at depressions, so that the interface between aluminum and the anodic oxidation film can be made smooth. A smooth surface can be obtained by removing the barrier film. More specifically, the method described in the text "New Theories on Anodized Aluminum" published by Kallos Publishing Co., Ltd., 1997, page 16 may be used.

The barrier film may be formed under these conditions and then dissolved or removed by using an aqueous chromic-phosphoric acid solution or by performing a chemical polishing, so that the mirror finished state can be further improved.

Method of Removing Barrier Film with Aqueous Chromic-Phosphoric Acid Solution
An aqueous solution of phosphoric acid and chromic acid is preferably used. More specifically, phosphoric acid, anhydrous chromic acid, and water are preferably used in the composition range to form a mixture.

**[Table8]**

| 85% Phosphoric acid | Anhydrous chromic acid | Water | Temperature | Standard immersion time |
|---|---|---|---|---|
| 100 to 140 g | 20 g to 40 | 1500 g | 50°C | 0.1µm/min. |

The method described in the literature: "Abstract of 108th Lecture Meeting" 18-B2, pages 76 to 77, published by The Surface Finishing Society of Japan may also be used.

After these polishing processes, the mean surface roughness shown in the table below is obtained in the directions parallel to and perpendicular to the rolling direction (generally indicated as centerline mean roughness Ra).

**[Table9]**

| Working method | R a [µm] |
|---|---|
| Mechanical polishing | 1 0 to 0. 1 |
| Chemical polishing | 0. 5 to 0. 2 |
| Electrolytic polishing | 0. 5 to 0. 1 |
| Electrolytic abrasive polishing | 0. 5 to 0. 01 |
| CMP method | <0. 05 |
| Barrier film removing method | <0. 05 |

### Anodizing Treatment

In the process of manufacturing the solar cell substrate according to the invention, an anodizing treatment is performed on the aluminum sheet having undergone any of the above mirror finishing processes. An insulating oxide film having a plurality of pores (micropores) is formed on the aluminum substrate by the anodizing treatment.

### Formation of Pits

A method of anodizing the surface of a member having an aluminum surface includes performing an anodizing treatment to form micropores (hereinafter also referred to as "main anodizing treatment"). Before the main anodizing treatment, pits are preferably formed, which will serve as start points for the formation of micropores in the main anodizing treatment. When such pits are formed, variations in the arrangement of micropores as described below or variations in the pore size can be easily controlled in the desired range.

Examples of methods for forming pits include, but are not limited to, a self-ordering method utilizing the self-ordering property of an anodic oxidation film, a physical method, a particle beam method, a block copolymer method, and a resist interference exposure method.

### (1) Self-Ordering Method

A self-ordering method includes utilizing the ability of an anodic oxidation film to form orderly arranged micropores and eliminating an ordered arrangement-disturbing factor to increase the order. Specifically, the self-ordering method includes providing a high-purity aluminum material, forming an anodic oxidation film thereon at a voltage according to the type of the electrolytic solution for a long time (for example, several hours to more than ten hours) at low speed, and then removing the film.
In this method, the pore size depends on the voltage, and therefore, the desired pore size can be obtained to some extent by controlling the voltage.

Typical known examples of self-ordering methods include methods as described in J. Electrochem. Soc. Vol. 144, No. 5, May 1997, p. L128 (Non-Patent Literature A), Jpn. J. Appl. Phys. Vol. 35 (1996) Pt. 2, No. 1B, L126 (Non-Patent Literature B), Appl. Phys. Lett., Vol. 71, No. 19, 10 Nov. 1997, p. 2771 (Non-Patent Literature C).
The methods described in these literatures are technically **characterized in that** the process is performed on a high-purity material at a specific voltage suitable for the electrolytic solution at relatively low temperature for long time. Specifically, all the self-ordering methods are performed on a material with an aluminum purity of 99.99% by weight or higher under the conditions shown below.

0.3 mol/L sulfuric acid, 0°C, 27 V, 450 minutes (Non-Patent Literature A)
0.3 mol/L sulfuric acid, 10°C, 25 V, 750 minutes (Non-Patent Literature A)
0.3 mol/L oxalic acid, 17°C, 40 to 60 V, 600 minutes (Non-Patent Literature B)
0.04 mol/L oxalic acid, 3°C, 80 V, a film thickness of 3 µm (Non-Patent Literature C)
0.3 mol/L phosphoric acid, 0°C, 195 V, 960 minutes (Non-Patent Literature C)

In the methods described in these publications, the process of removing the film includes dissolving the anodic oxidation film in an aqueous chromic acid-phosphoric acid mixture solution at about 50°C for 12 hours or more. The aqueous solution is used without being boiled, because if a boiling aqueous solution is used in the treatment, the start points for ordering will be destroyed and disturbed.

In the self-ordered anodic oxidation film, a portion closer to the aluminum component has higher order. Therefore, ordered pits can be obtained by once removing the film in such a manner that the bottom portion of the anodic oxidation film can be left on the aluminum component and exposed on the surface. In the film removing process, therefore, only the anodic oxidation film (aluminum oxide film) is dissolved without dissolving aluminum. As a result, the methods described in these publications keep variations in pore size (coefficients of variation) within 3% or less, although different micropore sizes are provided.

For example, the self-ordering anodizing treatment applicable to the production of the aluminum substrate for use in an embodiment of the invention may be performed using a method of energizing the aluminum member as an anode in a solution with an acid concentration of 1 to 10% by weight. Sulfuric acid, phosphoric acid, chromic acid, oxalic acid, sulfamic acid, benzenesulfonic acid, amidosulfonic acid, and so on may be used alone or in combination of two or more thereof in the solution for the anodizing treatment.

The self-ordering anodizing treatment conditions preferably include an electrolyte concentration of 1 to 10% by weight, a solution temperature of 0 to 20°C, a current density of 0.1 to 10 A/dm², a voltage of 10 to 200 V, and an electrolysis time of 2 to 20 hours, while they vary with the electrolyte used and is not automatically determined. The thickness of the self-ordered anodic oxidation film preferably has a thickness of 10 to 50 µm.

In an embodiment of the invention, the self-ordering anodizing treatment is preferably performed for 1 to 16 hours, more preferably 2 to 12 hours, even more preferably 2 to 7 hours.
The film removing process is preferably performed for 0.5 to 10 hours, more preferably 2 to 10 hours, even more preferably 4 to 10 hours.
Therefore, if the self-ordering anodizing treatment and the film removing process are performed for a short period of time as compared with known methods, the order of the micropore arrangement may be slightly degraded, and relatively large variations in pore size may be produced, so that the coefficient of variation may be in the range of 5 to 50%.

After the anodic oxidation film is formed by the self-ordering method and then dissolved and removed as described above, the main anodizing treatment described below may be performed again under the same conditions, so that substantially straight micropores can be formed perpendicular to the surface of the film.

### (2) Physical Method

An example of the physical method is a method employing press patterning. Specifically, such a method includes pressing, against the aluminum surface, a substrate whose surface has a plurality of projections, so that pits are formed on the aluminum surface. For example, the method described in JP-A No. 10-121292 may be used.
Another method includes densely arranging polystyrene balls on the aluminum surface, vapor-depositing SiO₂ thereon, then removing the polystyrene balls, and etching the substrate through the vapor-deposited SiO₂ as a mask to form pits.

### (3) Particle Beam Method

A particle beam method includes applying a particle beam to the aluminum surface to form pits. The particle beam method has the advantage that the pit position can be freely controlled.
Examples of the particle beam include a charged particle beam, a focused ion beam (FIB), and an electron beam.

When the particle beam method is used, the order of the pit positions may be disturbed using random numbers for the determination of the pit positions. This can disturb the order of the arrangement of micropores formed by the main anodizing treatment described below, so that the desired variations in pore size can easily be achieved.
The pit may be set at the desired position according to the formula below.

The coordinate of the desired position=(the coordinate of the perfectly ordered position)±(the coordinate of the perfectly ordered position) x (the coefficient of variation) x (random number)

When the sealing treatment is performed by electrodeposition, the coefficient of variation is preferably from 0.05 to 0.5, more preferably from 0.07 to 0.3, even more preferably from 0.1 to 0.2.
When the sealing treatment is performed by a method using colloidal metal particles, the coefficient of variation is determined in accordance with the particle size distribution of the colloidal metal particles used.

For example, the particle beam method described in JP-A No. 2001-105400 may also be used.

### (4) Block Copolymer Method

A block copolymer method includes forming a block copolymer layer on the aluminum surface, forming a sea-island structure in the block copolymer layer by thermal annealing, and removing the island portions to form pits. For example, the block copolymer method described in IP-A No. 2003-129288 may be used.

### (5) Resist Interference Exposure Method

A resist interference exposure method includes providing a resist on the aluminum surface and performing exposure and development on the resist to form pits passing through the resist to the aluminum surface.
For example, the resist interference exposure method described in JP-A No. 2000-315785 may be used.

Of the above various methods of forming pits, the self-ordering method, the FIB method, and the resist interference exposure method are desired, because they can uniformly form pits over a large surface area of about 10 cm square or more.
In view of manufacturing cost, the self-ordering method is most preferred. The FIB method is also preferred, because the arrangement of micropores can be freely controlled using it.

The pits formed preferably have a depth of about 10 nm or more and a width equal to or less than the desired pore size.

### Anodizing Treatment

The aluminum sheet having undergone the respective treatments as needed is subjected to an anodizing treatment so that an anodic oxidation film is formed.
The anodizing treatment may be performed according to an ordinary method in the art. Specifically, a direct current or an alternating current is applied to the aluminum sheet in an aqueous or nonaqueous solution of sulfuric acid, phosphoric acid, chromic acid, oxalic acid, sulfamic acid, or benzenesulfonic acid alone or combination of two or more thereof, so that an anodic oxidation film is formed on the surface of the aluminum sheet.

In general, the anodizing treatment conditions preferably include an electrolyte concentration of 0.1 to 1% by material weight of solution, a solution temperature of 5 to 70°C, DC, a current density of 1 to 50 A/dm², a voltage of 1 to 200 V, and an electrolysis time of 0.3 to 500 minutes, while they vary with the electrolyte used and is not automatically determined. In particular, an anodizing method using, as an electrolyte, a solution of sulfuric acid, phosphoric acid, oxalic acid, or mixture thereof is preferred. An anodizing method is more preferably performed in an electrolyte with a sulfuric, phosphoric or oxalic acid concentration of 0.1 to 1% by material weight at a temperature of 10 to 50°C with a direct current at a current density of 10 to 45 Adm⁻² and a voltage of 10 to 150 V. When anodic oxidation is performed at a current density of more than 25 Adm⁻², the anodizing treatment may include performing anoxic oxidation at a current density 20 to 40% lower than the target current density, then raising the voltage at a constant rate and performing anodic oxidation for half of the total anodizing time so that the target current density can be attained. This process makes it possible to prevent dielectric breakdown of the anodic oxidation film, which would otherwise be caused when a large current density is applied from the start.

Among these anodizing treatments, an anodizing method at high current density in a sulfuric acid electrolyte as described in British Patent No. 1,412,768 and an anodizing treatment in a phosphoric acid electrolytic bath as described in U.S. Patent No. 3,511,661 are particularly preferred. A multi-stage anodizing treatment may also be performed, which includes performing an anodizing treatment in sulfuric acid and then further performing anodizing treatment in phosphoric acid.

In an embodiment of the invention, the anodic oxidation film is preferably 0.5 g/m² (0.13 µm (alumina with a specific gravity of 4)) or more, more preferably 1.0 g/m² (0.25 µm (alumina with a specific gravity of 4)) or more, particularly preferably 2.0 g/m² (0.5 µm (alumina with a specific gravity of 4)) or more in view of scratch resistance and durability, and preferably 100 g/m² (25 µm (alumina with a specific gravity of 4)) or less, more preferably 10 g/m² (2.5 µm (alumina with a specific gravity of 4)) or less, particularly preferably 6 g/m² (1.5 µm (alumina with a specific gravity of 4)) or less, considering that a large amount of energy is necessary for the production of a thick film.

Fine pits called micropores are formed and uniformly distributed on the surface of the anodic oxidation film. The density of the micropores present on the anodic oxidation film may be controlled by appropriately controlling the treatment conditions.

The anodic oxidation film formed by the above method has pores with a pore diameter of 10 nm to 500 nm. In view of smoothness and maintaining insulating properties, the pore diameter is preferably 200 nm or less, more preferably 100 nm or less.

The density of the pores formed on the anodic oxidation film is generally from 100 to 10,000 per µm². In view of maintaining insulating properties, the pore density is preferably 5,000 per µm² or less, more preferably 1,000 per µm² or less

The anodic oxidation process may include placing the aluminum substrate in an electrolytic bath containing an electrolyte and applying a voltage between the aluminum substrate and the electrode to energize the substrate so that anodic oxidation is performed. When the electrode is placed to one side of the aluminum substrate, the anodic oxidation film is grown only on one side. Therefore, the anodic oxidation may be performed on each side (twice in total), so that both sides can be anodized. For example, the apparatus described in JP-A No. 2001-140100 or JP-A No. 2000-17499 may be used. When electrodes are placed to both sides of the aluminum substrate, both sides can be simultaneously anodized. In this case, the voltage applied to both sides may be controlled, or the current flow may be controlled by controlling the distance between each electrode and the aluminum substrate. In this case, alternatively, the concentration, temperature and/or components of the electrolyte on each of the front and back sides of the aluminum substrate may be controlled so that the thickness and quality of the anodic oxidation layer can be controlled on both sides.

Conventionally known anodizing methods may be used to form an anodized surface with low roughness or to control micropores. Such methods are preferably performed under the same conditions as those of the self-ordering method. The electrolysis voltage is preferably in the range of 10 V to 240 V, more preferably 10 V to 60 V.

Also preferably used is a method including repeating intermittent on-off control of current, while keeping DC voltage constant, or a method including repeating on-off control of current, while intermittently changing DC voltage. These methods are advantageous in that fine micropores are formed on the anodic oxidation film, so that uniformity is improved particularly in the process of sealing by electrodeposition.

In the method including intermittently changing the voltage, the voltage is preferably lowered step by step. This makes it possible to reduce the resistance of the anodic oxidation film, so that the subsequent electrodeposition can be uniformly performed, Contrarily, in order to form a highly-insulating, high-resistance film, the voltage is preferably increased step by step.

Once optimal conditions are substantially determined, the electrolysis may be performed at a constant voltage. A 0.3 M sulfuric acid electrolyte is preferably used for electrolysis at a constant low voltage of lower than 25 V±1 V. A 0.5 M oxalic acid electrolyte is preferably used for electrolysis at a constant voltage of lower than 40 V±1 V. If the voltage is increased by about 1 V or higher, the current may be locally concentrated at a certain part (generally called "burning"), so that uniform electrolysis may be impossible. If the voltage is decreased by about 1 V or higher, an irregular portion may be formed. Therefore, the above voltage range is preferred.

If the main anodizing treatment is performed at low temperature, micropores can be regularly arranged and uniform in pore size.
In an embodiment of the invention, the main anodizing treatment may be performed at relatively high temperature, so that the arrangement of micropores can be disturbed and that varieties in pore size can be easily kept in a specific range. Varieties in pore size may also be controlled by the treatment time.

The area ratio of the micropores is preferably from 20 to 50%. The area ratio of the micropores is the ratio of the total area of the openings of the micropores to the area of the aluminum surface. Micropores sealed with metal as well as those not sealed with metal are counted in the calculation of the area ratio of the micropores. Specifically, the surface porosity is measured before the sealing treatment and used to determine the surface porosity of the micropores.

In an exemplary method for manufacturing the solar cell of the invention, the aluminum sheet having undergone the mirror finishing process described above may be subjected to the main anodizing treatment under the conditions shown below.
(1) The anodizing treatment is performed using an aqueous sulfuric acid electrolyte with a concentration of 0.1 mol/L to 0.2 mol/L at a temperature of 12°C to 17°C and a voltage of 23 V to 26 V for a treatment time of 0.5 to 12 hours, so that micropores with an average pore size of 28 to 36 nm and an average pore interval of 40 to 80 nm are formed.
(2) The anodizing treatment is performed using an aqueous oxalic acid electrolyte with a concentration of 0.4 mol/L to 0.6 mol/L at a temperature of 12°C to 17°C and a voltage of 38 V to 42 V for a treatment time of 0.5 to 7 hours, so that micropores with an average pore size of 20 to 45 nm and an average pore interval of 80 to 120 nm are formed.
(3) The anodizing treatment is performed using an aqueous acid electrolyte with a concentration of 0.01 mol/L to 2 mol/L at a temperature of 0°C to 25°C and a voltage of 23 V to 400 V for a treatment time of 0.5 to 12 hours.

### Evaluation of Micropores

The average more size and the average pore interval of the pores may be determined by performing image analysis of an SEM surface photograph.

### Methods for Measuring Average Pore Size and Average Pore Interval

An SEM photograph is taken with an FE-SEM (field emission type scanning electron microscope) at a magnification of 1 to 150,000 diameters adjusted depending on the pore size. Using the photograph, the distance between the centers of adjacent pores is measured at 30 points, and the average of the 30 measurements is calculated as the average pore interval.
The magnification range is preferably such that there are 60 to 250 pores per field, more preferably 80 to 200 pores per field.
The average pore size may be determined by a process including tracing the contours of about 100 pores on a transparent OHP sheet and then approximating the pore sizes by the diameters of equivalent circles using commercially available image analysis software (Image Factory (trade name) manufactured by Asahi-Hi-Tech Co., Ltd.). The resulting value is defined as the average pore size. Any other image analysis software having a similar function may be alternatively used. However, the shapes traced on a transparent sheet such as an OHP sheet should preferably subjected to image analysis, because arbitrariness associated with the setting of the threshold in the binarization has to be eliminated as much as possible.

### Formation of Photoelectric Conversion Layer

The solar cell of the invention may be produced by forming a photoelectric conversion layer on the solar cell substrate described above. In an embodiment of the invention, the photoelectric conversion layer includes a chalcopyrite semiconductor material having a band gap of 1.3 to 1.5 eV.
First, both sides of the aluminum sheet are subjected to the treatments so that a solar cell substrate is produced, and then the solar cell substrate is dried. The drying process prevents contamination of the photoelectric conversion layer production with water. The life of the photoelectric conversion layer is prevented from being reduced by the contamination with water.
Preferably, a photoelectric conversion layer including a semiconductor composed of Group Ib elements, IIIb elements and VIb elements (Group I-III-VI semiconductor) is formed on the dried solar cell substrate so that a solar cell is obtained. It may further be bonded to a tempered glass plate with an adhesive such as ethylene vinyl acetate as described in JP-A No. 2007-123725, so that a solar cell module can be obtained. The photoelectric conversion layer is preferably a semiconductor layer containing at least one element selected from the group consisting of copper (Cu), silver (Ag), gallium (Ga), indium (In), sulfur (S), selenium (Se), and tellurium (Te). The photoelectric conversion layer preferably includes a CIGS semiconductor produced by a selenization technique, a selenization/sulfurization technique, a three-stage technique, or the like. Alternatively, however, the photoelectric conversion layer may include a semiconductor including a Group IVb element such as Si (Group IV semiconductor); a semiconductor composed of Group IIIb elements and Vb elements such as GaAs (Group III-V semiconductor); a semiconductor composed of Group IIb elements and VIb elements such as CdTe (Group II-VI semiconductor); or combination thereof. In the description, the short periodic table is used to group elements.
In the case of a Si semiconductor, amorphous silicon, a microcrystalline silicon thin film layer, a thin film of Ge-doped amorphous or microcrystalline silicon, or a tandem structure of two or more of these layers may be used to form the photoelectric conversion layer. Plasma CVD or the like may be used to form the film.

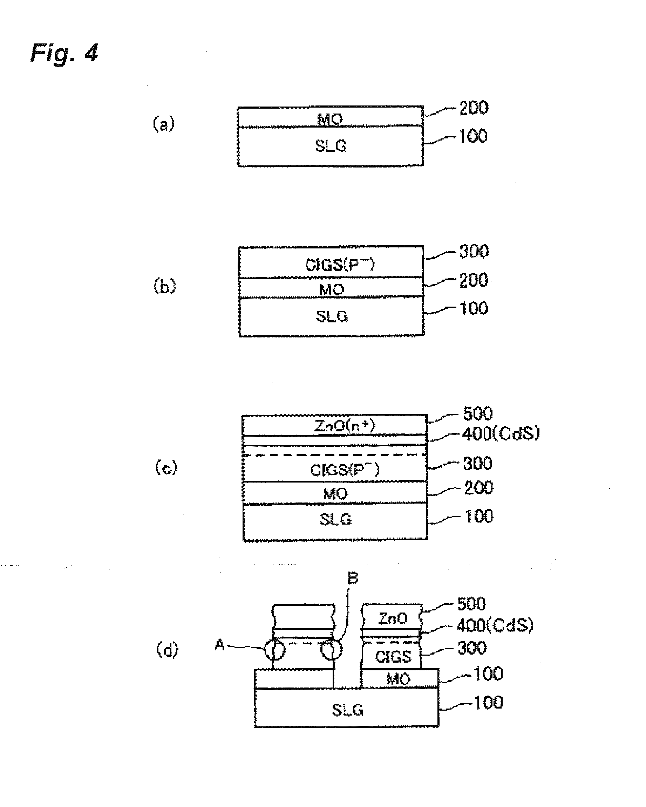

An example of the CIGS photoelectric conversion layer is shown below.
A thin-film solar cell having a light absorption layer including a chalcopyrite-structure semiconductor CuInSe₂ thin film (CIS thin film) composed of Group Ib elements, IIIb elements and VIb elements or Cu(In,Ga)Se₂ thin film (CIGS thin film), which contains a solid solution of Ga in the above semiconductor, has the advantages of high energy conversion efficiency and less degradation of the efficiency by light irradiation or the like. Figs. 4(a) to 4(d) are each a cross-sectional view of a device for illustrating a general method of producing cells of a CIGS thin-film solar battery cell.
As shown in Fig. 4(a), a Mo (molybdenum) electrode layer 200 to serve as a lower electrode on the plus side is first formed on an anodized aluminum substrate 100. As shown in Fig. 4(b), a light absorption layer 300 including a CIGS thin film and having a controlled composition to show p⁻ type is then formed on the Mo electrode layer 200. As shown in Fig. 4(c), a buffer layer 400 of CdS or the like is then formed on the light absorption layer 300, and a light-transmitting electrode layer 500 to serve as an upper electrode on the minus side, which includes ZnO (zinc oxide) and is doped with an impurity to show n⁺ type, is formed on the buffer layer 400. As shown in Fig. 4(d), a mechanical scribing apparatus is then used to scribe the part from the light-transmitting ZnO electrode layer 500 to the Mo electrode layer 200 at a time, so that the respective cells of a thin-film solar cell are electrically isolated from one another (namely, the cells are each individualized). Materials that may preferably be used to form films in apparatuses for the production of this exemplary embodiment are shown below.

(1) Materials including elements, compounds or alloys each capable of forming a liquid phase at ordinary temperature or upon heating.

(2) Chalcogen Compounds (compounds containing S, Se or Te)
II-VI Compounds: ZnS, ZnSe, ZnTe, CdS, CdSe, CdTe, etc.
Group I-III-VI₂ Compounds: CuInSe₂, CuGaSe₂, Cu(In,Ga)Se₂, Cu(In,Al)Se₂, Cu(In,B)Se₂, Cu(In,Ga,Al)Se₂, Cu(In,Ga,B)Se₂, Cu(In,Al,B)Se₂, Cu(In,Ga,Al,B)Se₂, CuInS₂, CuGaSe₂, Cu(In,Ga)(S,Se)₂, Cu(In,Al)(S,Se)₂, Cu(In,B)(S,Se)₂, Cu(In,Ga,Al)(S,Se)₂, Cu(In,Ga,B)(S,Se)₂, Cu(In,Al,B)(S,Se)₂, Cu(In,Ga,Al,B)(S,Se)₂, etc.
Group I-III₃-VI₅ Compounds: CuIn₃Se₅, CuGa₃Se₅, Cu(In,Ga)₃Se₅, etc.

(3) Chalcopyrite-Structure Compounds and Defect Stannite Structure Compounds
Group I-III-VI₂ Compounds: CuInSe₂, CuGaSe₂, Cu(In,Ga)Se₂, Cu(In,Al)Se₂, Cu(In,B)Se₂, Cu(In,Ga,Al)Se₂, Cu(In,Ga,B)Se₂, Cu(In,Al,B)Se₂, Cu(In,Ga,Al,B)Se₂, CuInS₂, CuGaSe₂, Cu(In,Ga)(S,Se)₂, Cu(In,Al)(S,Se)₂, Cu(In,B)(S,Se)₂, Cu(In,Ga,Al)(S,Se)₂, Cu(In,Ga,B)(S,Se)₂, Cu(In,Al,B)(S,Se)₂, Cu(In,Ga,Al,B)(S,Se)₂, etc.
Group I-III₃-VI₅ Compounds: CuIn₃Se₅, CuGa₃Se₅, Cu(In,Ga)₃Se₅, etc.

In the above formulae, (Al,A2,A3,A4) each means (Al_{1-X1-X2-X3- X4},A2_{X2},A3_{X3},A4_{X4}), wherein X1, X2, X3, and X4 each represent 0 to 1.

Typical methods for forming CIGS layers are described below, which are not intended to limit the scope of the invention.

### (1) Multi-Source Simultaneous Vapor Deposition

Typical methods of multi-source simultaneous vapor deposition include the three-stage method developed by NREL (National Renewable Energy Laboratory) in the United State and the simultaneous vapor deposition method by EC group. For example, the three-stage method described in J. R. Tuttle, J. S. Ward, A. Duda, T. A. Berens, M. A. Contreras, K. R. Ramanathan, A. L. Tennant, J. Kaene, E. D. Cole, K. Emery, and R. Nourfi: Mat. Res. Soc. Symp. Rroc., Vol. 426 (1996), p. 143. For example, the simultaneous vapor deposition method is described in L. Stolt et al.: Proc. 13th ECPVSEC (1995, Nice), 1451.

A three-stage method may include first simultaneously vapor-depositing In, Ga and Se under high vacuum at a substrate temperature of 300°C, then simultaneously vapor-depositing Cu and Se at a raised temperature of 500 to 560°C and then further simultaneously vapor-depositing In, Ga and Se, so that a graded band gap CIGS film having a graded band gap is obtained. The EC group method is an improvement of the bilayer process developed by The Boeing Company which includes vapor-depositing Cu-excess CIGS at an early stage and vapor-depositing In-excess CIGS at a later stage. The improvement makes the bilayer process applicable to in-line process. The bilayer process is described in W. E. Devaney, W. S. Chen, J. M. Stewart, and R. A. Mickelsen: IEEE Trans. Electron. Devices 37 (1990) 428.

The three-stage method and the EC group simultaneous vapor deposition produce a Cu-excess CIGS film composition in the course of film growth and employ liquid phase sintering of a phase-separated liquid phase Cu₂₋ₓSe (x=0-1). Therefore, they have the advantage that a large grain size is produced, so that a CIGS film with favorable crystallinity is formed.
In recent years, various processes for improving the crystallinity of the CIGS film have been studied in addition to these methods. Such processes may also be used.

### (a) Method Using Ionized Ga

The method includes allowing vaporized Ga to pass through a grid in which thermionic ions generated from a filament is present, so that Ga collides with the thermion to be ionized. The ionized Ga is accelerated by an extraction voltage and supplied to the substrate. A detailed description is given in H. Miyazaki, T. Miyake, Y. Chiba, A. Yamada, M. Konagai, Phys. Stat. Sol. (a), Vol. 203 (2006) p. 2603.

### (b) Method Using Cracked Se

In general, vaporized Se forms a cluster. This method includes thermally decomposing the Se cluster by a high-temperature heater to reduce the molecular size of the Se cluster (Proceedings of the 68th Meeting of the Japan Society of Applied Physics (Hokkaido Institute of Technology, autumn, 2007) 7P-L-6).

### (c) Method Using Se Radical

This method is performed using Se radicals generated from a valve tracking system (Proceedings of the 54th Meeting of the Japan Society of Applied Physics (Aoyama Gakuin University, spring, 2007) 29P-ZW-10).

### (d) Method Using Photo-Excitation Process

This method includes applying a KrF excimer laser beam (wavelength 248 nm, 100 Hz) or a YAG laser beam (e.g., wavelength 266 nm, 10 Hz) to the substrate surface during three-stage vapor deposition (Proceedings of the 54th Meeting of the Japan Society of Applied Physics (Aoyama Gakuin University, spring, 2007) 29P-ZW-14).

### (2) Selenization Technique

The selenization technique is also called a two-stage method, which includes first forming a metal precursor of a laminated film such as Cu layer/In layer or (Cu-Ga) layer/In layer by sputtering, vapor deposition, electrodeposition, or the like and heating the metal precursor at about 450 to about 550°C in a selenium vapor or hydrogen selenide so that a selenium compound such as Cu(In₁₋ₓGaₓ)Se₂ is produced by a thermal diffusion reaction. This method is called vapor phase selenization. Besides this method, there is a solid-phase selenization technique which includes depositing solid-phase selenium on a metal precursor film and performing selenization by a solid phased diffusion reaction using the solid-phase selenium as a selenium source. At present, only one method is successful for large area mass production, which includes forming a metal precursor film by a sputtering method suitable for large-area production and selenizing it in hydrogen selenide.

However, this method has a problem in which during selenization, the film expands to about twice its volume, so that internal distortion is generated and that about few µm voids are formed on the produced film, which have an adverse effect on the adhesion of the film to the substrate or the solar cell characteristics to cause restriction of photoelectric conversion efficiency (B. M. Basol, V. K. Kapur, C. R. Leidholm, R. Roe, A. Halani, and G. Norsworthy: NREL/SNL Photovoltaics Prog. Rev. Proc. 14th Conf.-A Joint Meeting (1996) AIP Conf. Proc. 394).

In order to avoid the abrupt volume expansion during selenization, there are proposed a method of previously mixing a certain amount of selenium into the metal precursor film (T. Nakada, R. Ohnishi, and A. Kunioka: "CuInSe2-Based Solar Cells by Se-Vapor Selenization from Se-Containing Precursors" Solar Energy Materials and Solar Cells 35 (1994) 204-214) and use of a multilayer precursor film including metal thin layers with selenium interposed therebetween (such as a laminate of Cu layer/In layer/Se layer...Cu layer/In layer/Se layer) (T. Nakada, K. Yuda, and A. Kunioka: "Thin Films of CuInSe2 Produced by Thermal Annealing of Multilayers with Ultra-Thin Stacked Elemental Layers" Proc. Of 10th European Photovoltaic Solar Energy Conference (1991) 887-890). The problem of the volume expansion is overcome to a certain extent by these techniques.

However, all the selenization techniques including these techniques have a certain problem, which is that the degree of freedom of film composition control is very low, because a metal laminated film having a specific composition is first used and then subjected to selenization. For example, a current high-efficiency CIGS solar cell uses a graded band gap CIGS thin film in which the Ga concentration is graded in the thickness direction. A method for producing such a thin film by selenization technique includes first depositing a Cu-Ga alloy film, depositing an In film thereon, and selenizing the laminate using spontaneous thermal diffusion so that the Ga concentration can be graded in the thickness direction (K. Kushiya, I. Sugiyama, M. Tachiyuki, T. Kase, Y. Nagoya, O. Yamase, and H. Takeshita: Tech. Digest 9th Photovoltaic Science and Engineering Conf. Miyazaki, 1996 (Intn. PVSEC-9, Tokyo, 1996) p. 149).

### (3) Sputtering Method

Since sputtering is suitable for large area production, many techniques have been proposed to form CuInSe₂ thin films. For example, there are disclosed a method using a CuInSe₂ polycrystal as a target and a two-source sputtering method using Cu₂Se and In₂Se₃ as targets and H₂Se-Ar mixed gas as sputtering gas (J. H. Ermer, R. B. Love, A. K. Khanna, S. C. Lewis, and F. Cohen: "CdS/CuInSe2 Junctions Fabricated by DC Magnetron Sputtering of Cu2Se and In2Se" Proc. 18th IEEE Photovoltaic Specialists Conf. (1985) 1655-1658). Three-source sputtering methods are also reported in which a Cu target, an In target and a Se or CuSe target are sputtered in Ar gas (T. Nakada, K. Migita, A. Kunioka: "Polycrystalline CuInSe2 Thin Films for Solar Cells by Three-Source Magnetron Sputtering" Jpn. J. Appl. Phys. 32 (1993) L1169-L1172 and T. Nakada, M. Nishioka, and A. Kunioka: "CuInSe2 Films for Selar Cells by Multi-Source Sputtering of Cu, In, and Se-Cu Binary Alloy" Proc. 4th Photovoltaic Science and Engineering Conf. (1989) 371-375).

### (4) Hybrid Sputtering Method

If the above sputtering methods have the problem of film surface damage by Se negative ions or high-energy Se particles, the problem should be avoided by converting only Se into hot vapor. Nakada et al. fabricated a CIS solar cell with a conversion efficiency of higher than 10% by forming a less-defective CIS thin film by a hybrid sputtering method in which Cu and In metal are sputtered by DC, while only Se is vapor-deposited (T. Nakada, K. Migita, S. Niki, and A. Kunioka: "Microstructural Characterization for Sputter-Deposited CuInSe2 Films and Photovoltaic Devices" Jpn. Appl. Phys. 34 (1995) 4715-4721). Prior to this, Rockett et al. reported a hybrid sputtering method to use Se vapor in place of toxic H₂Se gas (A. Rockett, T. C. Lommansson, L. C. Yang, H. Talieh, P. Campos, and J. A. Thornton: Proc. 20th IEEE Photovoltaic Specialists Conf. (1988) 1505). Even more before, a method of sputtering in Se vapor to complement a Se-deficient film with Se (S. Isomura, H. Kaneko, S. Tomioka, I. Nakatani, and K. Masumoto: Jpn. J. Appl. Phys. 19 (Suppl. 19-3) (1980) 23).

### (5) Mechanochemical Process

This process includes adding raw materials each with the corresponding composition for CIGS to the vessel of a planetary ball mill, mixing the raw materials by mechanical energy to obtain CIGS powder, then applying the powder to the substrate by screen printing, and annealing the print to obtain a CIGS film (T. Wada, Y. Matsuo, S. Nomura, Y. Nakamura, A. Miyamura, Y. Chia, A. Yamada, M. Konagai, Phys. Stat. Sol (a), Vol. 203 (2006) p2593).

### (6) Other Methods

Other CIGS film forming methods include a screen printing method, a close-spaced sublimation method, an MOCVD method, a spray method, and so on.
A thin film of fine particles composed of a Group Ib element, a Group IIIb element, a Group VIb element, and compounds thereof is formed on the substrate by a screen printing method, a spray method or the like and then subjected to heating such as heating in a Group VIb element atmosphere, so that a crystal with the desired composition is obtained. For example, oxide fine particles are applied to form a thin film, and then the thin film is heated in a hydrogen selenide atmosphere. A thin film of PVSEC-17 PL5-3 or an organometallic compound containing a metal-Group VIb element bond is formed on the substrate by spraying or printing and then thermally decomposed, so that the desired inorganic thin film is obtained. In the case of S, for example, the compounds listed below may be used (see for example JP-A Nos. 09-74065 and 09-74213). Metal mercaptide, metal thioate, metal dithioate, metal thiocarbonate, metal dithiocarbonate, metal trithiocarbonate, metal thiocarbamate, or metal dithiocarbamate.

### Band Gap Value and Control of Distribution Thereof

Semiconductors of various combinations of Group I-III-VI elements may be used for the light absorption layer of the solar cell. Fig. 5 shows well-known semiconductors. Fig. 5 is a diagram showing the relationship between the lattice constant and the band gap of semiconductors composed of Group Ib elements, IIIb elements and VIb elements. Various band gaps can be obtained by changing the composition ratio. When a photon incident on a semiconductor has energy greater than the band gap, the excess energy with respect to the band gap is lost as heat. A theoretical calculation indicates that a certain combination of a sunlight spectrum and a band gap of 1.4 to 1.5 eV can provide a maximum conversion efficiency. In order to increase the conversion efficiency of a CIGS solar cell, for example, the Ga concentration of Cu(InₓGa₁₋ₓ)S₂, the Al concentration of Cu(InₓAlₓ)S₂ or the S concentration of CuInGa(S,Se) may be increased so that a high-conversion-efficiency band gap can be obtained. The band gap of Cu(InₓGa₁₋ₓ)S₂ may be controlled to be in the range of 1 to 1.68 eV.

The band structure may also be biased by changing the composition ratio in the film thickness direction. There may be two graded band gap structures including: a single graded band gap structure in which the band gap increases in the direction from the light incidence window side to the opposite electrode side, and a double graded band gap structure in which the band gap decreases in the direction from the light incidence window to the PN junction and increases beyond the PN junction. For example, such solar batteries are disclosed in T. Dullweber, A new approach to high-efficiency solar cells by band gap grading in Cu(In,Ga)Se2 chalcopyrite semiconductors, Solar Energy Materials & Solar Cells, Vol. 67, p. 145-150 (2001). In all the cases, the carrier induced by light is accelerated by the internal electric field generated by the graded band structure so that it can easily arrive at the electrode, which decreases the probability of the coupling to the recombination center and therefore increases the power generation efficiency (reference literature: WO2004/090995).

### Tandem Type

When different semiconductors with different band gaps are used for different spectrum ranges, the heat loss due to the difference between the photon energy and the band gap can be reduced so that the power generation efficiency can be increased. Such a structure using a laminate of different photoelectric conversion layers is called tandem type. In the case of a two-layer tandem, for example, a combination of 1.1 eV and 1.7 eV may be used to improve the power generation efficiency.

### Structures Other Than Photoelectric Conversion Layer

Group II-VI compounds such as CdS, ZnO, ZnS, and Zn(O,S,OH) may be used as n-type semiconductors to form a junction with the Group I-III-VI compound semiconductor. These compounds are preferred, because they can form a junction interface free from recombination between the photoelectric conversion layer and the carrier. See for example JP-A NO. 2002-343987.

Metal such as molybdenum, chromium, or tungsten may be used to form the back surface electrode. These metal materials are preferred, because they are not susceptible to being mixed with other layers even in heat treatment. When a photovoltaic layer including a Group I-III-VI compound semiconductor layer (light absorption layer) is used, a molybdenum layer is preferably used. On the back surface electrode side, a recombination center is present at the interface between the light absorption layer CIGS and the back surface electrode. Therefore, if the contact area between the back surface electrode and the light absorption layer is unnecessarily excessive for electrical conduction, the power generation efficiency may be reduced. In order to reduce the contact area, for example, the electrode layer may have such a structure that an insulating material and a metal material are arranged in stripes. See for example JP-No. 09-219530.

Known materials such as ITO, ZnO:Ga, ZnO:Al, ZnO:B, and SnO₂ may be used to form transparent electrodes. These materials are preferred, because they are highly light-transmitting and have low resistance and high carrier mobility. See for example JP-A No. 11-284211.

Examples of the layer structure include a superstrate type and a substrate type. When a photovoltaic layer including a Group I-III-VI compound semiconductor layer (light absorption layer) is used, a substrate type structure is preferably used, because of its high conventions efficiency.

### Buffer Layer, Window Layer and Transparent Electrode

Examples of the buffer layer may include CdS, ZnS, ZnS (O, OH), and ZnMgO. Examples of the window layer may include various transparent conductive materials such as ZnO and ITO. If for example the Ga concentration of CIGS is raised to increase the band gap of the light absorption layer, the conduction band becomes too large as compared to the conduction band of ZnO, and therefore the use of ZnMgO having large energy in the conduction band is preferable for the buffer layer. The buffer layer in the band structure including the CIGS/the buffer layer/the window layer (ZnO) can be prevented from having a spike shape (upward protrusion) and causing a drop in saturation current or a cliff shape (recess) and causing a drop in release current to lower FF, so that the power generation efficiency can be increased when the band gap is large.

### Prevention of Peeling, Adhesion Improvement

### Application of Adhesive Layer

A buffer layer of Ti is used at the interface between Mo or W as a back surface electrode and CuInSe2, Ti diffuses and reacts with Mo and Cu as a semiconductor forming element in heat treatment during formation of semiconductor, so that a chemically adhesive mechanism can be established and a high-quality ternary semiconductor thin film can be obtained with high reproducibility (see JP-A No. 5-315633).
A buffer layer of Ta, Cr, Nb, Ti, or titanium nitride having a thermal expansion coefficient halfway between Al and Mo may be interposed between the Mo electrode layer and an anodized aluminum substrate, so that electrode peeling attributable to the difference in expansion coefficient between Mo and Al during high temperature process can be prevented (see JP-A No. 06-252433 and Japanese Patent Application National Publication No. 09-503346).

Back Surface Electrode Junction Interface Reduction
A comb-like or grid-type back surface electrode is preferably used. A metal electrode of Mo, W, Ti, Ta, Au, Pt, Ni, Cr, Ag, or Al is preferably used (see JP-A Nos. 09-172193 and 09-219530).

### Adjustment of Film Stress of Back Surface Electrode

In a sputtering method, the substrate temperature, the film forming rate, sputtering gas pressure, etc. have an effect on film formability. The relationship between the metal sputtering gas pressure and the film stress and electrical resistance was examined into details by John A. Thornton and David W. Hoffman (see J. Vac. Sci. Technol., Vol.14,No.1,Jan./Feb.1977). When a Mo film is so formed that compressive stress is from 0 to 0.4 GPa, the generation of MoSeₓ responsible for peeling of a CIS tin film and an increase in contact resistance can be reduced (see JP-A Nos. 10-135501 and 2000-12883).

### Back Surface Electrode Suitable for Na Addition

A preferred structure includes at least two conductive layers and a Group Ia element-containing layer provided between the conductive layers, so that segregation of Na at the surface of the anodized aluminum substrate can be prevented, although the in-plane uniformity is not good. The thermal expansion coefficient of Mo in general use is small as compared to those of the CIGS film and the substrate, and therefore peeling may occur during the manufacturing process that includes a high temperature procedure such as a CIGS film forming step. As means for solving the problem of the peeling from the substrate, a method of layering Mo films was reported by John H. Schofield et al. (Thin Solid Films, 260, (1995), pp. 26-31). A multi-layer film is less likely to be peeled off. Examples of the Group Ia element-containing layer include Na₂S, Na₂Se, NaCl, NaF, sodium molybdate, and aluminum oxide layers.
When the crystal grain size of the lowermost layer in the conductive layer is greater than the crystal grain size of the uppermost layer, the adhesion to the substrate is improved, and the layer is less likely to be peeled off from the substrate even after the high temperature process such as the step of forming films such as a compound semiconductor layer for a solar cell. On the other hand, the layer having a grain size smaller than this has better conductivity. When the lowermost layer of the conductive layer has a smaller density than that of the uppermost layer, the adhesion to the substrate is improved, and the layer is less likely to be peeled off from the substrate even after the high temperature process such as the step of forming films such as a compound semiconductor layer for a solar cell. On the other hand, the layer having a greater density than the above in the conductive layer has improved conductivity (see JP-A 2004-79858).
The back surface electrode may be formed to have two layers, for example into such a structure as CIGS/Mo/Cr/anodized aluminum substrate, the diffusion amount of Na may be controlled by the thickness of Cr, and the Mo film forming conditions may be relaxed. This facilitates both the control of the shape of the Mo surface and the achievement of high conductivity of the back surface electrode (see PVSC2008 poster 298).

### Alkaline Barrier

A precursor containing In, Cu, and Ga metal elements is formed on a back surface electrode layer, and then the substrate coated with an aqueous sodium molybdate-containing aqueous solution is subjected to heat treatment in a H₂Se gas atmosphere. A two-layer alkaline barrier layer is formed, which includes a silica layer and a first layer of a multi-layer metal back surface electrode layer (having its crystal grain size adjusted) (see JP-A Nos. 2006-210424 and 2006-165386).
A discussion about the effect of forming the alkaline barrier layer upon a solar cell characteristic reached a conclusion that the alkaline barrier layer is necessary (see David F. Dawson-Elli,el al., "Substrate Influences On CIS Device Performance," Proc.1st World Conference of Photovoltaic Energy Conversion(1995)152-155, C.Jensen, "The Study of Base Electrode/Substrate Interactions By Use of Air Anneal Imaging," Proc.13th European photovoltaic Solar Energy Conference(1995), JP-A Nos. 11-312517 and 2006-165386).
There is an example using a manufacturing process including intentionally forming an alkaline barrier layer (TiN, Al₂O₃, SiO₂, Si₃N₄, ZrO₂, TiO₂ or the like) capable of completely preventing diffusion of an alkaline component from a blue plate glass substrate, forming a metal back surface electrode thereon, and further forming another layer containing a necessary amount ofNa to produce a solar cell. In this example, such an alkaline barrier layer is intentionally produced, the metal back surface electrode is formed thereon, and then a layer containing an necessary amount of Na, K, Li, or the like is separately produced (by adding a compound such as Na₂S or Na₂Se by doping) (see V.Probst,el al., "Large Area CIS Formation By Rapid Thermal Processing Of Stacked Elemental Layers," Proc. 17the European Photovoltaic Solar Energy Conference (2002) 1005-1010, V. Probst, el al., "Advanced Stacked a CIS Formation By Rapid Thermal Processing Of Stacked Elemental Layer Process For Cu(InGa)Se2. Thin Film Photovoltaic Device, Mat. Res. Soc. Symp. Proc., Vol. 426 (1996) 165-176, J. Holz, et al.,: Proc. 12th European Photovoltaic Solar Energy Conference (1994) 1592-1595, JP-A Nos. 08-222750, 2007-266626, and 2003-318424).
In the above-described studies, an independent alkaline barrier layer including oxide, nitride or the like is formed on a blue plate glass substrate, and diffusion of the alkaline component from the blue plate glass substrate is related to the film forming methods (R. J. Araujo, el al., "Sodium Redistribution Between Oxide Phases," Journal of Non-Crystalline Solids, 197 (1996) 154-163). On the other hand, it was reported that a metal back surface electrode layer alone without an alkaline barrier layer can only partly block diffusion of an alkaline component (J. Holz, et al.: Proc. 12th European Photovoltaic Solar Energy Conference (1994) 1592-1595).

### Scribing

In a solar cell actually used, a plurality of cells are packaged and processed as a module (panel). A plurality of unit cells are connected in series by each scribing step. In a thin-film solar cell, the number of series stages (the number of unit cells) may be changed so that the cell voltage can be changed and designed as desired. This is one of the advantages of the thin-film solar cell. When a solar cell having such an integrated structure is formed, the process includes first scribing to separate a Mo back surface electrode, second scribing to separate a light absorption layer in order to electrically connect a transparent electrode and the back surface electrode of an adjacent cell, and third scribing to separate the transparent electrode. A transparent electrode is provided on a groove formed after the second scribing so that electrical conduction is established according to conventional techniques. Alternatively, the light absorption layer may be modified by light irradiation so that conduction can be established, which can reduce the number of the scribing steps to two. The light absorption layer at the conducting portion has a greater Cu/In ratio. In other words, the layer has a p+ type or conductive characteristic with a small amount of In (see JP-A Nos. 2007-109842, 2007-123532, 2007-201304, 2007-317858, 2007-317868, 2007-317879, and 2007-317885). Disclosed prior art related to scribing includes a technique of scraping a light absorption layer and a buffer layer by moving and pressing a tip-tapered metal needle under predetermined pressure (see JP-A No. 2004-115356), and a technique including applying, to a light absorption layer, a laser beam emitted from a Nd:YAG crystal excited by a continuous discharge lamp such as an arc lamp (Nd:YAG laser), so that the light absorption layer is removed and divided (see JF-A No. 11-312815).

In laser scribing, the capability of scraping a target depends on the energy density, the pulse time, and the wavelength. The target material is preferably used at high-light-absorption wavelength. The processing threshold power is different by an order of magnitude between 1064 nm and 532 nm. The pulse time is preferably 0.1 ns rather than 10 ns, and the processing is enabled when the energy density is at least several J/cm². The beam profile of the laser beam is preferably adjusted to prevent the upper edge of the scribed groove from being raised, and an anisotropic focused beam produced with a cylindrical lens is effective (see Optics and Lasers in Engineering 34, P. 15 (2000)).
The needle pressure for scribing is actively controlled to be constant to a target. A plurality of needles are arranged in a comb shape, so that the needles can be controlled at a time. Resistance between wires disconnected by scribing is measured to determine whether the electrode is favorable, and defective products are excluded. When cutting of the Mo electrode is unsuccessful, all the succeeding steps will be wasted. Powder or gas generated during scribing is sucked by an intake port near the needle or the laser irradiation outlet, and the powder or gas is removed using a filter if necessary (see JENOPTIK GmbH pamphlet).

In order to prevent defects from being formed in a light absorption layer by scribing stress, an underlying electrode layer (Mo), a p-type compound semiconductor thin film (CIGS thin film) having a chalcopyrite structure that serves as a light absorption layer, and an n-type light transmitting electrode layer (ZnO) are patterned by etching by photolithography, and the CIGS thin-film is subjected to two-stage etching including dry etching and wet etching, so that high precision patterning can be achieved with no damages or defects generated in the compound semiconductor crystal and with no residual liquid (see JP-A 2007-123721).

### In-Situ Monitoring

Transition from a copper-rich composition to a copper-poor composition on a base material is detected by a sensor that detects a physical parameter related to the transition such as radiation. Using a sensor that detects the composition of elements in a vapor-deposited layer, a controller connected to the sensor regulates the flow rate from the vapor source in order to provide a CIGS layer having a homogeneous composition and a uniform thickness along the width of the base material. The thermal conductivity may be obtained from differential temperature measurement between two locations, or the thermal capacity, the resistivity, or the intensity of light reflected or transmitted by the deposited CIGS film may be used. The deposited amounts of the elements of the CIGS film are measured with an XRF (X-ray fluorescent) device, an EDX (energy diffusion X-ray spectroscopy) device, or a surface profilometer, and the total deposited amount of each element (Cu, Ga, In, Se) is measured, so that the thickness and composition of the deposited CIGS layer are determined or the relative amount of Cu to In+Ga is controlled (see Japanese Patent Application National Publication No. 2007-527121).

### Improvement of Conversion Efficiency by Increasing Back Surface Reflection Light

A composite back surface contact layer is formed between the substrate and the light absorption layer. At the time, the layer includes a back surface reflector layer that raises the reflectivity, a contact layer that secures an appropriate electrical characteristic for the back surface contact, and/or a conductance layer that secures low sheet resistance with respect to in-plane current (see Japanese Patent Application National Publication No. 2007-528600).

### Addition of Na

An oxide thin film Cu-In-O:Na₂O₂ composed of Group Ib elements and IIIa elements and doped with a Group Ia oxide Na₂O₂ that serves as a dopant is deposited on a precursor layer formed by a selenization method, and then subjected to heat treatment in an atmosphere containing a Group VIa element (an Ar-hydrogen gas mixture containing H₂Se) (see JP-A No. 09-55378).
An alkaline metal such as Na is added to the first layer in a two-stage growth method (see JP-A No. 10-74966). The ratio of the Group Ib element to the Group III element included in the light absorption layer doped with the Group IIa element is from 0.22 or higher to 0.75 or lower in the composition used (see JP-A No. 10-74967).

The solar cell of the invention is produced with an inexpensive lightweight anodized aluminum substrate and therefore has a reduced weight and high thermal conductivity and is flexible and less fragile. Furthermore, the light supply layer can be thinned using the light confining effect, so that the battery can be produced less costly. The anodic oxidation layer may be provided on both sides and the end face of the metal substrate, and pores may be filled with another insulating material, so that not only insulation can be ensured, but also a chemical reaction of the metal substrate can be prevented in the process of forming the films for the solar cell. When the substrate provided with the anodic oxidation film on both sides is used, thermal distortions are cancelled between both sides, so that the deformation of the substrate such as curling and curving can be prevented. The textured structure formed on the substrate surface improves the adhesion between the substrate and the metal electrode, so that film peeling can be prevented.
The light confining effect is small if the surface roughness is relatively small according to conventional techniques. However, the light confining effect can be increased by using the pore structure in combination. The textured structure allows more light to be confined in the light absorption layer.

### EXAMPLES

The present invention will be described in more detail based on the following examples, but the invention is not intended to be limited thereby.

First, the conditions and the methods of the treatment and the measurement performed in the examples are described below.

### 1. Polishing of Aluminum Sheet

The aluminum material used was a custom made 5N aluminum sheet with an area of 5 cm x 5 cm manufactured by Nippon Light Metal Co., Ltd. (analytical result (wt%): Al, 99.999% or higher; Cu, lower than 0.0002%; Si, lower than 0.0002%; Fe, lower than 0.0002%). The aluminum material was polished using the mechanical polishing method described below.

### (A1) Mechanical polishing

A polishing machine LaboPol-5 (trade name) manufactured by Marumoto Struers K.K. was used.
A 5 cm square sample was bonded to a mirror finished metal block with a double-sided adhesive tape (removable tape 9455 manufactured by Sumitomo 3M Limited). The sample was polished with abrasive paper sheets in the order of increasing grit number (#80-#240-#500-#1,000-#1,200-#1,500) until no surface asperities were visualiy observed.
The abrasive paper sheets used were Waterproof Abrasive Paper (trade name) manufactured by Marumoto Struers K.K.

### (A2) Mechanical polishing

A polishing machine LaboPol-5 (trade name) manufactured by Marumoto Struers K.K. was used.
A 5 cm square sample was bonded to a mirror finished metal block with a double-sided adhesive tape (removable tape 9455 manufactured by Sumitomo 3M Limited). Polishing was sequentially performed using abrasives and polishing clothes, which were changed as shown below, until no surface asperities were visually observed.
Abrasives: Diamond Abrasive DP-Spray P series (trade name) manufactured by Marumoto Struers K.K. in the order of SPRIR (particle size, 45 µm), SPRAM (particle size, 25 µm), SPRUF (particle size, 15 µm), SPRAC (particle size, 9 µm), SPRIX (particle size, 6 µm), SPRRET (particle size, 3 µm), SPRON (particle size, 1 µm), and SPRYT (particle size, 0.25 µm).

Buffing was performed using the above diamond slurries in the order of coarse to fine, so that a mirror-finished state was obtained. The buff was changed when the abrasive was changed.
The buffs used were polishing cloths No. 773 (particle size, 10 µm or more) and No. 751 (particle size, less than 10 µm) manufactured by Marumoto Struers K.K.
In all the cases, the residual blister density was 0 per dm², Ra was 0.1 µm, and the average glossiness was 75%.

### 2. Evaluation of Polished Surface

### Evaluation of Surface Roughness

The surface roughness Ra was first measured with a contact-probe profilometer. Thereafter, when Ra was 0.1 µm or less, it was measured with AFM. When the Ra is 0.1 µm or more, a sapphire probe with a tip diameter of 10 µm was used for the measurement. Otherwise, AFM was used for the measurement.

### (1) Measurement of Ra with Profilometer (according to JIS-B 601 (1994)).

The Ra was determined by folding the roughness curve at the centerline and dividing the area between the roughness curve and the centerline by the length L, which was expressed in micrometer (µm). Model: SURFCOM 575A (trade name) manufactured by Tokyo Seimitsu Co., Ltd.
Measurement conditions: cut off, 0.8 mm; gradient correction, FLAT-ML; sampling length, 2.5 mm; T-speed, 0.3 mm/second; polarity, positive.
Probe: sapphire probe with a tip diameter of 10 µm

### (2) Measurement of Ra with AFM

When Ra was 0.1 µm or less, a roughness was measured with AFM (DFM cyclic contact mode).
Scanning area: 3000 nm
Scanning frequency: 0.5 Hz
Amplitude attenuation: -0.16
I gain: 0.0749 / P gain: 0.0488
Q curve gain: 2.00
Vibrating voltage: 0.044 V
Resonance frequency: 318.5 kHz
Measurement frequency: 318.2 kHz
Vibration amplitude: 0.995 V
Q value: approximately 460
Measurement stylus: Si stylus with a tip diameter of 10 nm (cantilever SI DF40P (trade name) manufactured by Seiko Instruments Inc.)

### Example 1

The surface of the mechanically-polished, rolled aluminum sheet with a thickness of 0.24 mm was grained with a rotary nylon brush (6-10 nylon) and an aqueous suspension of 20% by weight of 400 mesh Pumice Stone (trade name, manufactured by Kyoritsu Ceramics Materials Co., Ltd.) and then thoroughly washed with water. The aluminum sheet was immersed in an aqueous 10% by weight sodium hydroxide solution (containing 5% by weight of aluminum) and so etched that aluminum was dissolved in an amount of 5 g/m² Thereafter, the aluminum sheet was washed with running water, further neutralized with 20% by weight nitric acid, and then washed with water.

The aluminum sheet was then subjected to a surface roughening treatment with an anodic electric quantity of 160 Coulomb/dm² in an aqueous 1% by weight nitric acid solution (containing 0.5% of aluminum) using a rectangular alternating waveform voltage with an anodic voltage of 10.5 V and a cathodic voltage of 9.3 V (current ratio r=0.90, the current waveform shown in the example of JP-B No. 58-5796). After washed with water, the aluminum sheet was immersed in an aqueous 10% by weight sodium hydroxide solution at 40°C and so etched that aluminum was dissolved in an amount of 1 g/m², and then washed with water. Thereafter, the aluminum sheet was immersed and desmutted in an aqueous 30% by weight sulfuric acid solution at 55°C for 2 minutes and then washed with water.

The aluminum sheet was then subjected to an anodizing treatment in an aqueous 30% by weight sulfuric acid solution (containing 0.8% by weight of aluminum) at 50°C using a DC voltage of 20 V for an electrolysis time of 6 minutes so that a 5 µm thick oxide film was obtained. The aluminum sheet was further washed with water and dried.

Any ten portions of the resulting aluminum support were sampled and measured for the respective physical properties. The anodic oxidation film on the back side was subjected to platinum-palladium vapor deposition so that a sample was obtained. The sample was observed with an ultra-high resolution scanning electron microscope. As a result, the pore density and the pore size were measured to be 1.03 to 1.50 × 10¹¹ per cm² (average 1.3 × 10¹¹ per cm², 1,300 per µm²) and 30 nm, respectively. The centerline mean roughness Ra was 0.56 µm.

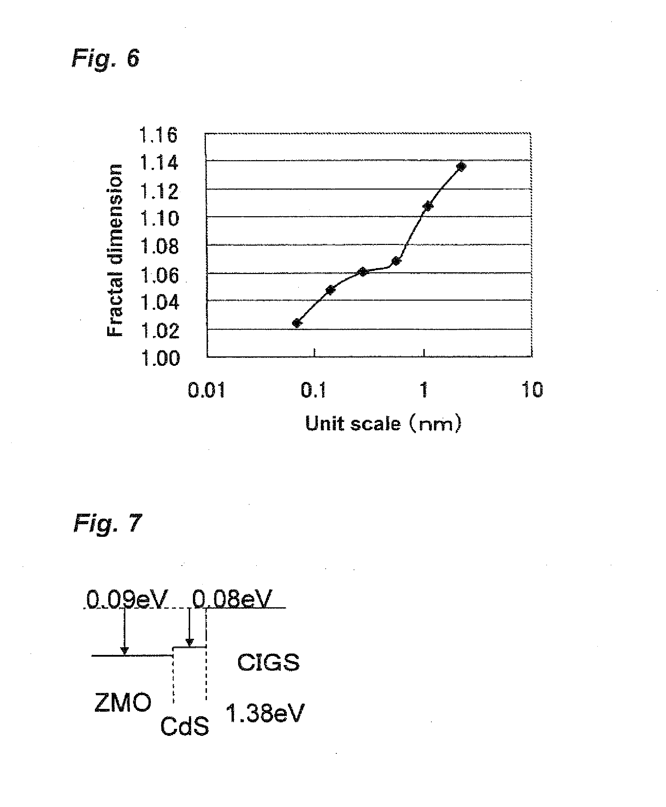

The surface profile of the anodized aluminum substrate was measured with AFM, and the cross-sectional shape was evaluated by a box counting method. The results are shown in Fig. 6, which indicates that the fractal dimension is higher than 1 and lower than 1.99 and that the fractal dimension decreases with decreasing unit scale

The prepared solar cell substrate was used, and a chalcopyrite structure CuIGaSe₂ thin film (CIGS thin film) was formed thereon so that a solar cell was obtained. In this example, disc-shaped targets of high-purity copper, indium (99.9999% in purity), high-purity Ga (99.999% in purity), and high-purity Se (99.999% in purity) were used.
A 0.8 µm thick molybdenum film was deposited on the solar cell substrate. The size was 3 cm × 3 cm. A chromel-alumel thermocouple was used as a substrate temperature monitor.
First, the main vacuum chamber was evacuated to 10⁻⁶ Torr, and then high-purity argon gas (99.999%) was introduced into the sputtering chamber, and the pressured was controlled to 3 × 10⁻² Torr with a variable leak valve.
The CIS thin film was then formed as a light absorption layer so that a solar cell was prepared. The battery had the structure ZnO:Al film/CdS film/CIGS film/Mo film/substrate (from the light incidence side). An about 2 µm thick CIGS thin film was formed on the lower electrode. The film was produced under such conditions that the vapor deposition rate from each evaporation source was controlled at a maximum substrate temperature of 550°C. The prepared CIGS film had a thickness of about 2 µm. An about 90 nm CdS thin film was then deposited as a buffer layer by a solution growth method. A 0.6 µm thick ZnO;Al film as a transparent conductive film was formed thereon by an RF sputtering method. Finally, an Al grid electrode was formed as an upper electrode by a vapor deposition method.

### Performance Evaluation

The solar cell of Example 1 has an insulating layer surface that satisfies the structural requirements of the solar cell insulating substrate according to the invention, and also has high light utilizing efficiency.

### Example 2

The sample of Example 1 according to the invention was used as a substrate. After a Mo layer was formed on the anodized aluminum substrate by RF sputtering (high frequency sputtering), a NaF layer was formed thereon by RF sputtering and a Mo layer was further formed thereon by RF sputtering. The resulting Mo/NaF/Mo multilayer film had a thickness of about 1.0 µm. A CuInGaSe₂ thin film was deposited on the Mo film in a vacuum chamber. In the deposition of the CuInGaSe₂ thin film, a Cu (the primary component of CuInGaSe₂) evaporation source, an In evaporation source, a Ga evaporation source, and a Se evaporation source were provided in the vacuum chamber 1, and the Cu, In, Ga, Se evaporation source crucibles were heated at the degree of vacuum of about 10⁻⁷ Torr so that each element was evaporated. In this process, the crucible temperature was controlled as needed. The CuInGaSe₂ thin film was formed to have a two-layer structure as described below. The first layer of the two-layer structure was so formed that Cu was in excess of the total of In and Ga in the atomic composition, and the second layer of the two-layer structure was subsequently so formed that the total of In and Ga was in excess of Cu in the atomic composition. The substrate temperature was kept constant at 550°C. The first layer was vapor-deposited with a thickness of about 2 µm. At this time, the atomic composition ratio Cu/(In+Ga) was about from 1.0 to 1.2. The second layer was then vapor-deposited with a thickness of about 1 µm so that the final atomic composition ratio Cu/(In+Ga) and the band gap could be 0.8 to 0.9 and 1.38 eV (Ga/(Ga+Cu)=56%), respectively.

Plural semiconductor layers were then formed as window layers. First, an about 50 nm thick CdS film was deposited by a chemical deposition method. The chemical deposition method was performed by heating at about 80°C an aqueous solution containing Cd nitrate, thiourea and ammonia and immersing the light absorption layer in the aqueous solution. An about 80 nm thick ZnO film was further formed on the CdS film by an MOCVD method.
An about 200 nm thick Zn_{0.96}Mg_{0.04}O film was then deposited as a transparent conductive film by an MOCVD method. Fig. 7 shows the band gap of the solar cell prepared in this example.
Finally, Al was vapor-deposited to form an extraction electrode, so that a solar cell was obtained.

The characteristics of the resulting solar cell were evaluated using simulated sunlight under the conditions of an Air Mass (AM) of 1.5 and 100 mW/cm². As a result, a conversion efficiency of 10.0% was obtained. The result indicates that even when the anodized aluminum substrate according to the invention is used to form a solar cell, the resulting solar cell shows sufficient photoelectric conversion efficiency.

### Example 3

The surface of the mechanically-polished, rolled aluminum sheet with a thickness of 0.24 mm was grained with a rotary nylon brush (6-10 nylon) and an aqueous suspension of 20% by weight of 400 mesh Pumice Stone (trade name, manufactured by Kyoritsu Ceramics Materials Co., Ltd.) and then thoroughly washed with water. The aluminum sheet was immersed in an aqueous 10% by weight sodium hydroxide solution (containing 5% by weight of aluminum) and so etched that aluminum was dissolved in an amount of 5 g/m². Thereafter, the aluminum sheet was washed with running water, further neutralized with 20% by weight nitric acid, and then washed with water.

The aluminum sheet was then subjected to a surface roughening treatment with an anodic electric quantity of 160 Coulomb/dm² in an aqueous 1% by weight nitric acid solution (containing 0.5% of aluminum) using a rectangular alternating waveform voltage with an anodic voltage of 10.5 V and a cathodic voltage of 9.3 V (current ratio r=0.90, the current waveform shown in the example of JP-B No. 58-5796). After washed with water, the aluminum sheet was immersed in an aqueous 10% by weight sodium hydroxide solution at 40°C and so etched that aluminum was dissolved in an amount of 1 g/m², and then washed with water. Thereafter, the aluminum sheet was immersed and desmutted in an aqueous 30% by weight sulfuric acid solution at 55°C for 2 minutes and then washed with water.

Plural aluminum sheets were then subjected to an anodizing treatment in an aqueous 30% by weight sulfuric acid solution (containing 0.8% by weight of aluminum) at 10 to 50°C using a DC voltage of 5 to 20 V for an electrolysis time of 1 to 10 minutes so that 5 µm thick oxide films were obtained. The aluminum sheets were further washed with water and dried.

Any ten portions of the resulting aluminum support were sampled and measured for surface roughnesses, pore sizes and pore densities. The anodic oxidation film on the back side was subjected to platinum-palladium vapor deposition so that a sample was obtained. The sample was observed with an ultra-high resolution scanning electron microscope. The results are shown in Table 10.

After a Mo layer was formed on the anodized aluminum substrate by RF sputtering (high frequency sputtering), a NaF layer was formed thereon by RF sputtering, and a Mo layer was further formed thereon by RF sputtering. The resulting Mo/NaF/Mo multilayer film had a thickness of about 1.0 µm. A CuInGaSe₂ thin film was deposited on the Mo film in a vacuum chamber. In the deposition of the CuInGaSe₂ thin film, a Cu (the primary component of CuInGaSe₂) evaporation source, an In evaporation source, a Ga evaporation source, and a Se evaporation source were provided in the vacuum chamber 1, and the Cu, In, Ga, Se evaporation source crucibles were heated at the degree of vacuum of about 10⁻⁷ Torr so that each element was evaporated. In this process, the crucible temperature was controlled as needed. The CuInGaSe₂ thin film was formed to have a two-layer structure as described below. The first layer of the two-layer structure was so formed that Cu was in excess of the total of In and Ga in the atomic composition, and the second layer of the two-layer structure was subsequently so formed that the total of In and Ga was in excess of Cu in the atomic composition. The substrate temperature was kept constant at 550°C. The first layer was vapor-deposited with a thickness of about 2 µm. At this time, the atomic composition ratio Cu/(In+Ga) was about from 1.0 to 1.2. The second layer was then vapor-deposited with a thickness of about 1 µm so that the final atomic composition ratio Cu/(In+Ga) and the band gap could be 0.8 to 0.9 and 1.38 eV (Ga/(Ga+Cu)=56%), respectively.

Plural semiconductor layers were then formed as window layers. First, an about 50 nm thick CdS film was deposited by a chemical deposition method. The chemical deposition method was performed by heating at about 80°C an aqueous solution containing Cd nitrate, thiourea and ammonia and immersing the light absorption layer in the aqueous solution. An about 80 nm thick ZnO film was further formed on the CdS film by an MOCVD method.
An about 200 nm thick Zn_{0.96}Mg_{0.04}O film was then deposited as a transparent conductive film by an MOCVD method. Fig. 7 shows the band gap of the solar cell prepared in this example.
Finally, Al was vapor-deposited to form an extraction electrode, so that a solar cell was obtained.

The characteristics(the power generation efficiency) of the resulting solar cell were evaluated using simulated sunlight under the conditions of an Air Mass (AM) of 1.5 and 100 mW/cm². The results are shown in Table 10.

[Table10]

**Table 1 0**

| Name of sample | Surface roughness nm | Pore size nm | Pore density /µm² | Power generation efficiency % |
|---|---|---|---|---|
| 1 | 0.2 | 3 | 28900 | 6 |
| 2 | 0.2 | 7 | 10000 | 5.6 |
| 3 | 0.6 | 11 | 10000 | 7.4 |
| 4 | 10 | 15 | 8100 | 7.8 |
| 5 | 120 | 15 | 4096 | 8.6 |
| 6 | 330 | 30 | 2025 | 9.1 |
| 7 | 550 | 45 | 1024 | 10.2 |
| 8 | 800 | 60 | 900 | 10.5 |
| 9 | 1200 | 80 | 625 | 10.3 |
| 10 | 1500 | 120 | 441 | 10.1 |
| 11 | 2000 | 140 | 121 | 8.4 |
| 12 | 3000 | 180 | 81 | 6.1 |
| 13 | 4400 | 225 | 49 | 5.5 |
| 14 | 8700 | 500 | 25 | 5.4 |

Table 10 shows that an electric generation efficiency of 8% or higher is obtained with a surface roughness in the range of 0.5 nm to 2 µm, a pore size in the range of 11 to 140 nm, and a pore density in the range of 100 to 10,000 /µm² and that the resulting solar cell functions well.

### INDUSTRIAL APPLICABILITY

The invention provides a lightweight and less fragile solar cell having high thermal conductivity, high peeling resistance for its photoelectric conversion layer, and favorable voltage resistance. Therefore, the solar cell of the invention is suitable for use in flexible solar batteries.

Having described our invention as related to the present embodiments, it is our intention that the invention not be limited by any of the details of the description, unless otherwise specified, but rather be construed broadly within its spirit and scope as set out in the accompanying claims.

This non-provisional application claims priority under 3S U.S.C. § 119 (a) on Patent Application No. 2007-255664 filed in Japan on September 28, 2007 and Patent Application No. 2008-088958 filed in Japan on March 30, 2008, each of which is entirely herein incorporated by reference.

## Claims

1. A solar cell, comprising: a metal substrate having an insulating anodic oxidation film; and a photoelectric conversion layer provided on the metal substrate, wherein the anodic oxidation film has a surface roughness of 0.5 nm to 2 µm, and the photoelectric conversion layer comprises a chalcopyrite semiconductor material having a band gap of 1.3 eV to 1.5 eV.

2. The solar cell of Claim 1, wherein the roughness of the anodic oxidation film is 0.5µm to 1.5µm.

3. The solar cell of Claim 1 or 2, wherein pores with a pore size of 10 nm to 500 nm are formed on the surface of the anodic oxidation film.

4. The solar cell of Claim 3, wherein the pores have a pore size of 10 nm to 200 nm.

5. The solar cell of any one of Claims 1 to 4, wherein the pores satisfy the relationship D>R, wherein D is a distance between the centers of the adjacent pores formed on the anodic oxidation film, and R is a pore diameter, and wherein the pores are present at a density of 100 to 10,000 per µm².

6. The solar cell of any one of Claims 1 to 5, wherein the pores have a depth of 0.005 to 199.995 µm.

7. The solar cell of any one of Claims 1 to 6, wherein the anodic oxidation film has a textured surface structure defined by fractal analysis, wavelet analysis or Fourier transform method.

8. The solar cell of Claim 7, wherein the textured structure includes a fractal structure with a fractal dimension of higher than 2 to 2.99.

9. The solar cell of Claim 8, wherein the fractal dimension is higher than 2 to 2.99, when a unit length is more than 1 nm to 100 µm in size.

10. The solar cell of Claim 7, wherein a cross section of the textured structure has a fractal structure with a fractal dimension of higher than 1 to 1.99.

11. The solar cell of Claim 10, wherein the fractal dimension is higher than 1 but not higher than 1.99, when the unit length is more than 1 nm to 100 µm in size.

12. The solar cell of any one of Claims 1 to 11, wherein the anodic oxidation film is formed on an end face and both sides of the metal substrate.

13. The solar cell of any one of Claims 1 to 12, wherein the photoelectric conversion layer comprises a semiconductor layer comprising Group Ib elements, IIIb elements and VIb elements.

14. The solar cell of Claim 13, wherein the semiconductor layer comprises at least one element selected from the group consisting of copper (Cu), silver (Ag), indium (In), gallium (Ga), sulfur (S), selenium (Se), and tellurium (Te).

15. The solar cell of any one of Claims 1 to 12, wherein the photoelectric conversion layer comprises a semiconductor layer comprising a Group IVb element, a semiconductor layer comprising Group IIIb elements and Vb elements, a semiconductor layer comprising Group IIb elements and VIb elements, a layer comprising a Group Ib element, a layer comprising a Group IIb element, a layer comprising a Group IVb element, and/or a layer comprising a Group VIb element.
